# EUROPEAN PATENT SPECIFICATION

(11) **EP 4 059 912 B1**
(45) Date of publication and mention of the grant of the patent: **13.11.2024**
(21) Application number: 20888263.9
(22) Date of filing: 13.11.2020
(51) Int. Cl.: C04B 35/587, C04B 35/64, H05K 1/02, H05K 1/03, H05K 3/00, C04B 35/581, C04B 35/593, C04B 35/638, C04B 37/02

(54) **CERAMIC SUBSTRATE, COMPOSITE SUBSTRATE, CIRCUIT BOARD, METHOD FOR PRODUCING CERAMIC SUBSTRATE, METHOD FOR PRODUCING COMPOSITE SUBSTRATE, METHOD FOR PRODUCING CIRCUIT BOARD, AND METHOD FOR PRODUCING PLURALITY OF CIRCUIT BOARDS**
KERAMIKSUBSTRAT, VERBUNDSUBSTRAT, LEITERPLATTE, VERFAHREN ZUR HERSTELLUNG EINES KERAMISCHEN SUBSTRATS, VERFAHREN ZUR HERSTELLUNG EINES VERBUNDSUBSTRATS, VERFAHREN ZUR HERSTELLUNG EINER LEITERPLATTE UND VERFAHREN ZUR HERSTELLUNG VON MEHREREN LEITERPLATTEN
SUBSTRAT CÉRAMIQUE, SUBSTRAT COMPOSITE, CARTE DE CIRCUIT IMPRIMÉ, PROCÉDÉ DE PRODUCTION DE SUBSTRAT CÉRAMIQUE, PROCÉDÉ DE PRODUCTION DE SUBSTRAT COMPOSITE, PROCÉDÉ DE PRODUCTION DE CARTE DE CIRCUIT IMPRIMÉ, ET PROCÉDÉ POUR LA PRODUCTION D'UNE PLURALITÉ DE CARTES DE CIRCUIT IMPRIMÉ

(30) Priority: 15.11.2019 JP 2019206751
(43) Date of publication of application: 21.09.2022
(73) Proprietor: Denka Company Limited, Tokyo 103-8338 (JP)
(72) Inventor: TSUGAWA,Yuta, Tokyo 103-8338 (JP); NISHIMURA,Koji, Tokyo 103-8338 (JP); KOBASHI ,Seiji, Tokyo 103-8338 (JP); ESHIMA, Yoshiyuki, Tokyo 103-8338 (JP); YUASA, Akimasa, Tokyo 103-8338 (JP)
(74) Representative: Gulde & Partner
(86) International application number: PCT/JP2020/042421
(87) International publication number: WO 2021/095844

(56) References cited:
- WO-A1-2013/146789
- JP-A- 2007 019 123
- JP-A- 2007 198 626
- JP-A- 2008 186 897
- JP-A- 2008 186 897
- JP-A- 2017 178 715
- JP-A- H02 141 476
- US-A1- 2005 269 749

## Description

### TECHNICAL FIELD

The present invention relates to a ceramic substrate, a composite substrate, a circuit substrate, a manufacturing method of a ceramic substrate, a method of cutting a ceramic substrate, a manufacturing method of a composite substrate, a manufacturing method of a circuit substrate, and a manufacturing method of a plurality of circuit substrates.

### BACKGROUND ART

For example, as in JP 2018-18971 A, it is known that metal layers are fixed to both surface sides of a ceramic substrate to produce a composite substrate and a circuit pattern is formed on one of the metal layers of the composite substrate to produce a circuit substrate. This circuit substrate is excellent from the viewpoint of high thermal conductivity and high insulating properties and thus used for, for example, power modules.

After that, such a ceramic substrate undergoes a metal layer-forming step of fixing the metal layers (for example, copper sheets) to both surface sides of the ceramic substrate, a circuit pattern-forming step of forming a circuit pattern on at least one of the metal layers, and a scribe line-forming step to be processed into a circuit substrate.

JP 2017 178715 A and WO 2013/146789 A1 describe methods for manufacturing ceramic substrates having low warpage and waviness. In order to achieve this, a load is applied on the stack of green sheets during the sintering process.

### SUMMARY OF THE INVENTION

### TECHNICAL PROBLEM

Incidentally, in recent years, a request for the flatness of circuit substrates has been intensifying more and more. In order to meet such a request, it is required to reduce thermal strain or thermal stress remaining in circuit substrates on a higher level.

An object of the present invention is to provide a ceramic substrate enabling the production of a circuit substrate having excellent flatness in which residual thermal strain or residual thermal stress is significantly reduced.

### SOLUTION TO PROBLEM

A ceramic substrate of according to the present invention is a ceramic substrate having a rectangular shape in a plan view, in which, at a location deviating from an intersection formed by a pair of diagonal lines of the ceramic substrate, at least one convex portion that is convex toward one side or the other side in a sheet thickness direction is formed, a value obtained by dividing a maximum projection amount of the at least one convex portion by a length of the diagonal line of the ceramic substrate is equal to or less than 2 pm/mm, the convex portion having the maximum projection amount among said convex portions that are convex toward one side or the other in the sheet thickness direction is at the outer peripheral edge portions of said ceramic substrate, wherein the diagonal lines have a length of 150 mm or more and the outer peripheral edge portion is an area within 3 mm from the outer edge of the ceramic substrate.

A composite substrate according to the present invention includes the ceramic substrate, a first metal layer fixed to a front surface side of the ceramic substrate, and a second metal layer fixed to a rear surface side of the ceramic substrate.

A circuit substrate according to the present invention includes the ceramic substrate, a circuit pattern formed on a front surface side of the ceramic substrate, and a metal layer fixed to a rear surface side of the ceramic substrate.

A manufacturing method of a ceramic substrate according to the present invention is a manufacturing method of the ceramic substrate including a strip-shaped green sheet-cutting step of cutting a strip-shaped green sheet containing a ceramic powder to obtain an individual green sheet and a sintering step of disposing the individual green sheet in a firing chamber, heating an inside of the firing chamber until a temperature in the firing chamber reaches at least equal to or higher than 1600°C, then, cooling the inside of the firing chamber, and sintering the individual green sheet to obtain the ceramic substrate, wherein the sintering step comprises a cooling region in which the temperature in the firing chamber is cooled at a cooling rate of 100 °C/hour or more, the cooling region including a rapid cooling region in which the cooling rate is further increased when the temperature in the firing chamber during the cooling of the inside of the firing chamber reaches a temperature of equal to or lower than 650°C.

A method of cutting a ceramic substrate according the present invention comprises the manufacturing method of the ceramic substrate, and further including a ceramic substrate-cutting step of cutting portions on entire peripheral edge sides of the ceramic substrate cooled after the sintering step.

A manufacturing method of a ceramic substrate of another aspect of the present invention is the manufacturing method of the ceramic substrate, in which the ceramic powder contains silicon nitride powder or aluminum nitride powder.

A manufacturing method of a composite substrate of the present invention includes the manufacturing method of the ceramic substrate and a fixing step of fixing a first metal layer to a front surface side of the ceramic substrate and fixing a second metal layer to a rear surface side.

A manufacturing method of a circuit substrate of the present invention includes the manufacturing method of the composite substrate and a pattern-forming step of forming at least one circuit pattern on any one of the first metal layer and the second metal layer.

A manufacturing method of a plurality of circuit substrates of the present invention includes the manufacturing method of a composite substrate, a pattern-forming step of forming a plurality of circuit patterns on any one of the first metal layer and the second metal layer, and a dividing step of dividing the composite substrate on which the plurality of circuit patterns have been formed into a plurality of circuit substrates each having one circuit pattern.

### ADVANTAGEOUS EFFECTS OF INVENTION

According to the ceramic substrate of the present invention, it is possible to produce a circuit substrate having excellent flatness in which residual thermal strain or residual thermal stress is significantly reduced.

### BRIEF DESCRIPTION OF THE DRAWINGS

Fig. 1 is a flow chart showing a manufacturing method of a plurality of mounting substrates of the present embodiment.
Fig. 2A is a flow chart of a green sheet-forming step included in the manufacturing method of a plurality of mounting substrates of the present embodiment.
Fig. 2B is a view for describing a molding step included in the green sheet-forming step of the present embodiment and a schematic view for describing a state where a strip-shaped green sheet is being produced from a slurry using a doctor blade molding device.
Fig. 2C is a view for describing a cutting step included in the green sheet-forming step of the present embodiment and a schematic view (side view) for describing a state where the strip-shaped green sheet is cut using a cutting device to produce an individual green sheet.
Fig. 2D is a schematic view of Fig. 2C viewed from the front side.
Fig. 3A is a view for describing a deposition step included in the green sheet-forming step of the present embodiment to a sintering step in the manufacturing method of a plurality of mounting substrates of the present embodiment.
Fig. 3B is a graph showing a profile of firing temperatures in the sintering step (also including conditions studied by a test) .
Fig. 3C is a graph showing a relationship between rapid cooling start temperatures in a firing step (also including conditions studied by a test) and warpage amounts.
Fig. 3D is a plan view of a ceramic substrate as a first example of the present embodiment and a high/low distribution map with a high/low degree (concave condition) profile in a sheet thickness direction attached thereto.
Fig. 3E is a cross-sectional view (end face view) of the ceramic substrate as the first example of Fig. 3D and a cross-sectional view cut along an A-A cutting line.
Fig. 3F is a cross-sectional view (end face view) of the ceramic substrate as the first example of Fig. 3D and a cross-sectional view cut along a B-B cutting line.
Fig. 3G is a plan view of a ceramic substrate as a second example of the present embodiment and a high/low distribution map with a high/low degree (concave condition) profile in a sheet thickness direction attached thereto.
Fig. 3H is a cross-sectional view (end face view) of the ceramic substrate as the second example of Fig. 3G and a cross-sectional view cut along an A-A cutting line.
Fig. 3I is a cross-sectional view (end face view) of the ceramic substrate as the second example of Fig. 3G and a cross-sectional view cut along a B-B cutting line.
Fig. 3J is a plan view of a ceramic substrate as a third example of the present embodiment and a high/low distribution map with a high/low degree (concave condition) profile in a sheet thickness direction attached thereto.
Fig. 3K is a cross-sectional view (end face view) of the ceramic substrate as the third example of Fig. 3J and a cross-sectional view cut along an A-A cutting line.
Fig. 3L is a cross-sectional view (end face view) of the ceramic substrate as the third example of Fig. 3J and a cross-sectional view cut along a B-B cutting line.
Fig. 3M is a plan view of a ceramic substrate as a fourth example of the present embodiment and a high/low distribution map with a high/low degree (concave condition) profile in a sheet thickness direction attached thereto.
Fig. 3N is a cross-sectional view (end face view) of the ceramic substrate as the fourth example of Fig. 3M and a cross-sectional view cut along an A-A cutting line.
Fig. 3O is a cross-sectional view (end face view) of the ceramic substrate as the fourth example of Fig. 3M and a cross-sectional view cut along a B-B cutting line.
Fig. 3P is a plan view of a ceramic substrate as a fifth example of the present embodiment and a high/low distribution map with a high/low degree (concave condition) profile in a sheet thickness direction attached thereto.
Fig. 3Q is a cross-sectional view (end face view) of the ceramic substrate as the fifth example of Fig. 3P and a cross-sectional view cut along an A-A cutting line.
Fig. 3R is a cross-sectional view (end face view) of the ceramic substrate as the fifth example of Fig. 3P and a cross-sectional view cut along a B-B cutting line.
Fig. 3S is a plan view of a ceramic substrate as a sixth example of the present embodiment and a high/low distribution map (70 um span) with a high/low degree (concave condition) profile in a sheet thickness direction attached thereto.
Fig. 3T is a plan view of the ceramic substrate as the sixth example of the present embodiment and a high/low distribution map (100 um span) with a high/low degree (concave condition) profile in a sheet thickness direction attached thereto.
Fig. 3U is a plan view of the ceramic substrate as the sixth example of the present embodiment and a high/low distribution map (200 um span) with a high/low degree (concave condition) profile in a sheet thickness direction attached thereto.
Fig. 3V is a plan view of the ceramic substrate as the sixth example of the present embodiment and a high/low distribution map (300 um span) with a high/low degree (concave condition) profile in a sheet thickness direction attached thereto.
Fig. 3W is a graph showing a displacement amount distribution measured along a laser three-dimensional shape measuring instrument along C-C straight lines in Fig. 3S to Fig. 3V.
Fig. 4A is a schematic view for describing an outer peripheral portion-cutting step included in the manufacturing method of a plurality of mounting substrates of the present embodiment.
Fig. 4B is a graph showing a relationship between cut widths of the outer peripheral portion and warpage amounts in the outer peripheral portion-cutting step.
Fig. 5 is a view for describing a scribe line-forming step included in the manufacturing method of a plurality of mounting substrates of the present embodiment.
Fig. 6A is a view for describing a metal layer-forming step included in the manufacturing method of a plurality of mounting substrates of the present embodiment.
Fig. 6B is a cross-sectional view of the ceramic substrate of Fig. 6A and a horizontal cross-sectional view cut by a 6B-6B cutting line.
Fig. 7 is a view for describing a resist-printing step included in the manufacturing method of a plurality of mounting substrates of the present embodiment.
Fig. 8 is a view for describing an etching step included in the manufacturing method of a plurality of mounting substrates of the present embodiment.
Fig. 9 is a view for describing a dividing step included in the manufacturing method of a plurality of mounting substrates of the present embodiment.
Fig. 10 is a view for describing a metal layer-forming step of a modification example.

### DESCRIPTION OF EMBODIMENTS

### <<Overview>>

Hereinafter, the present embodiment will be described with reference to the drawings.

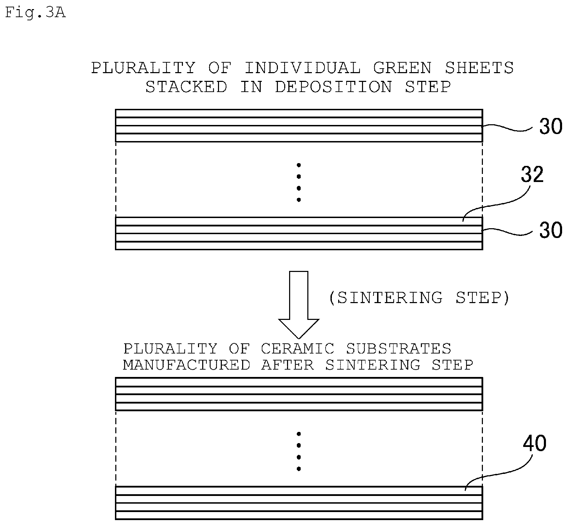

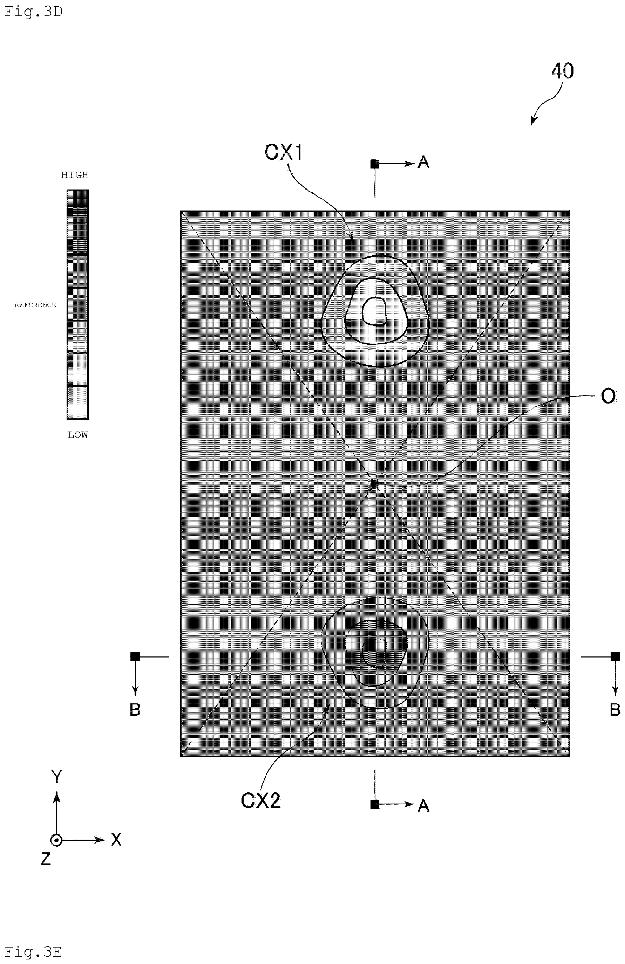

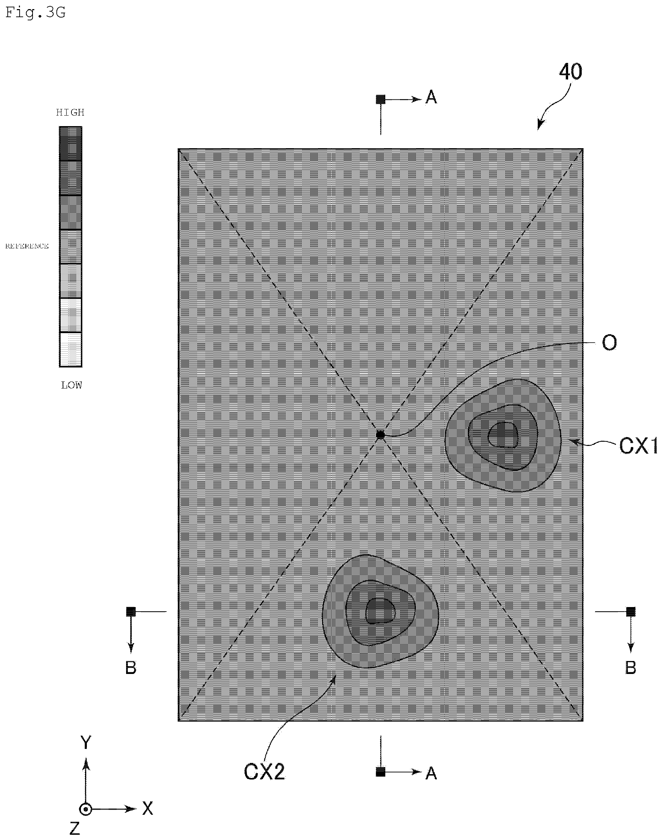

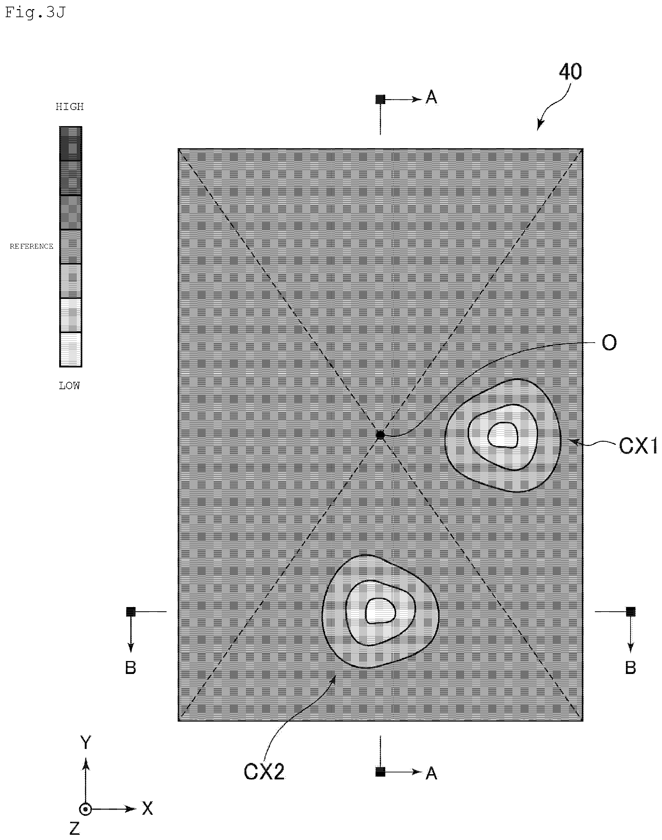

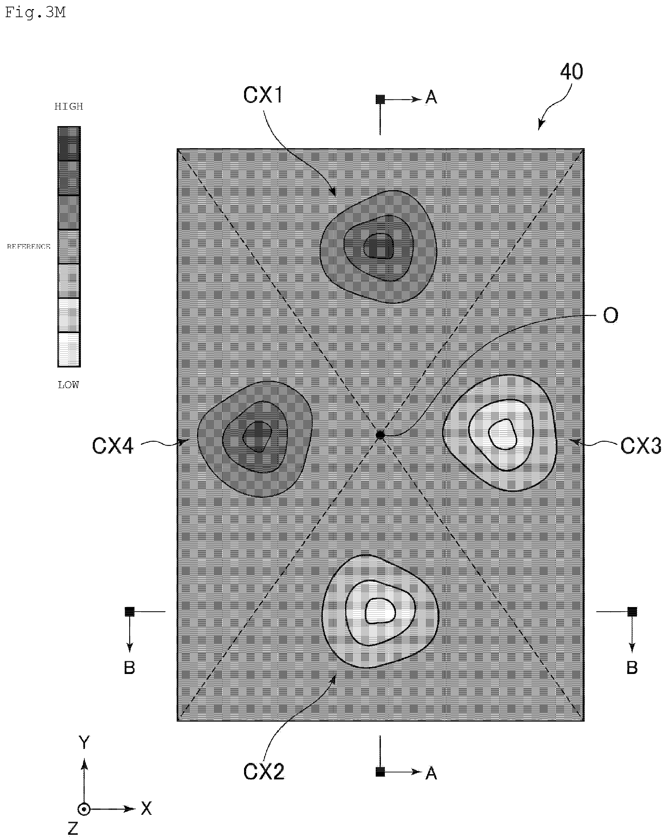

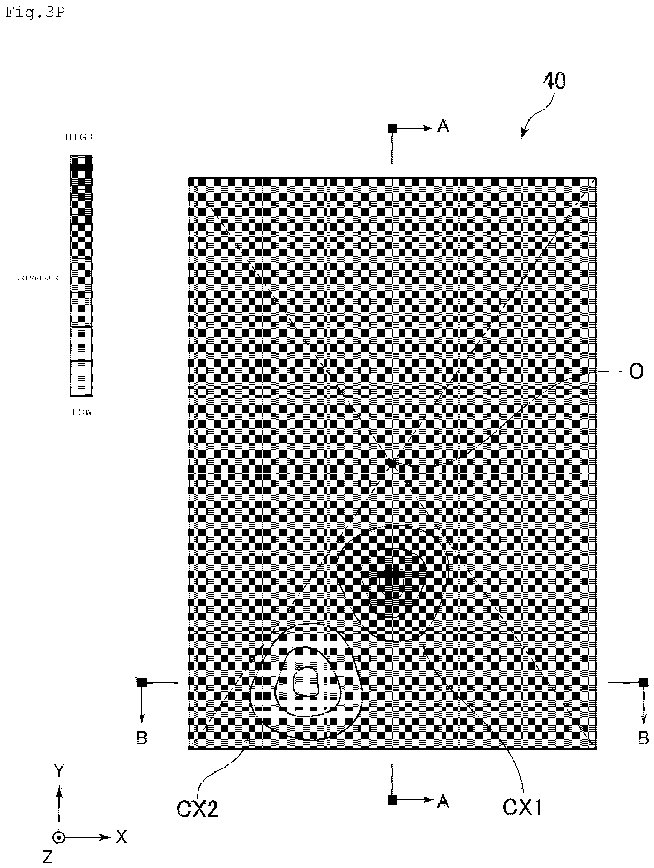

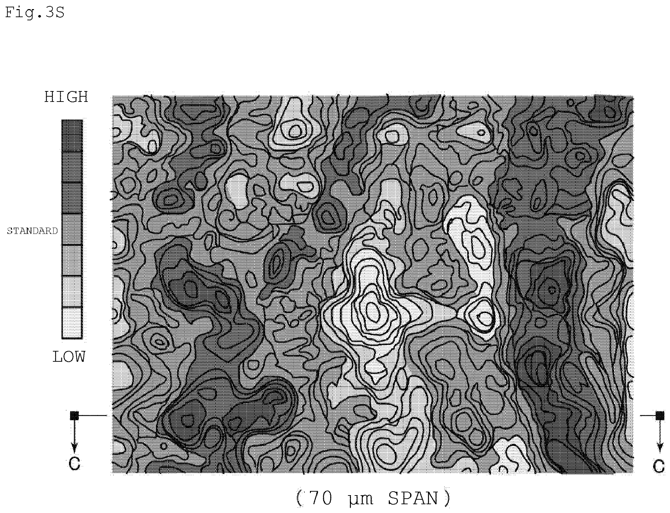

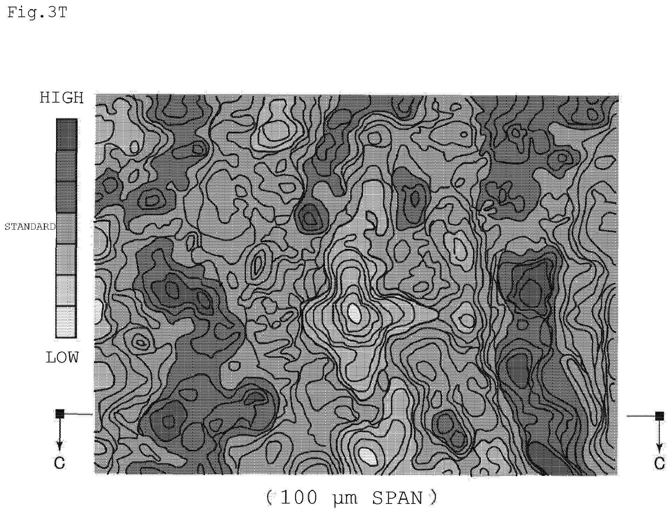

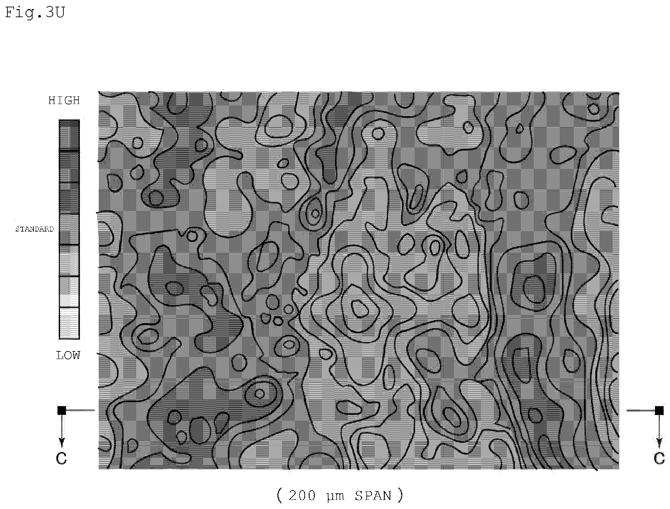

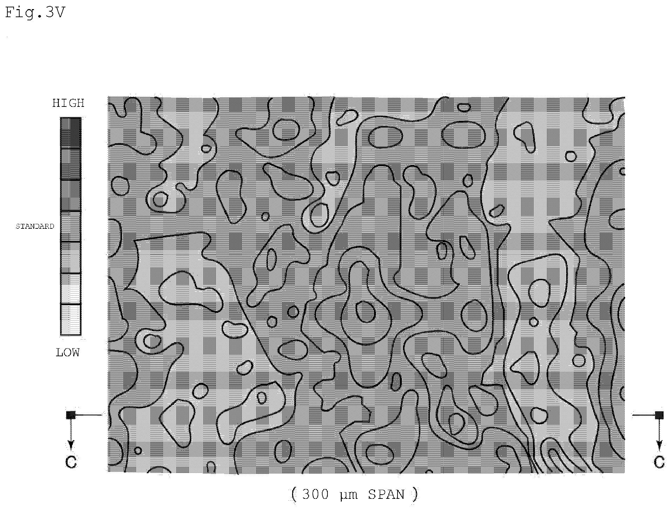

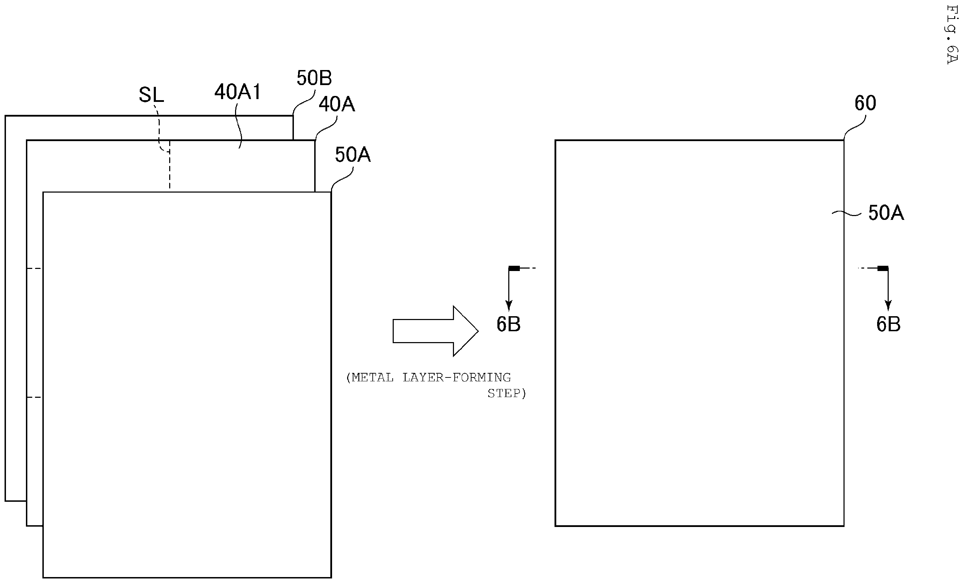

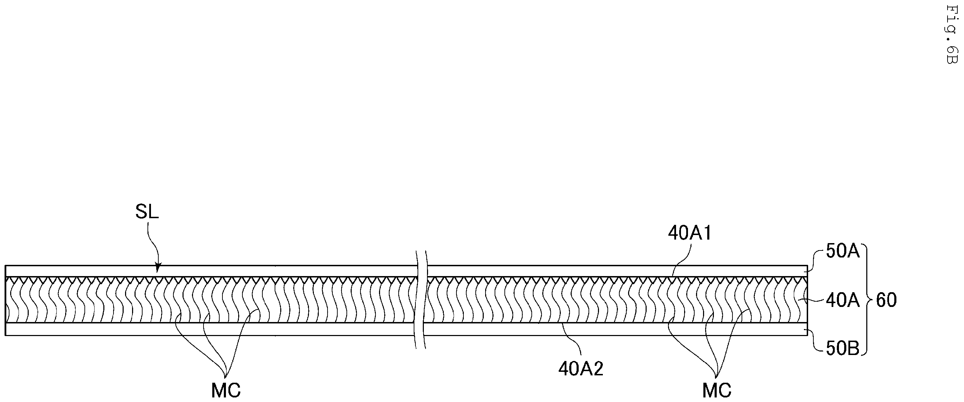

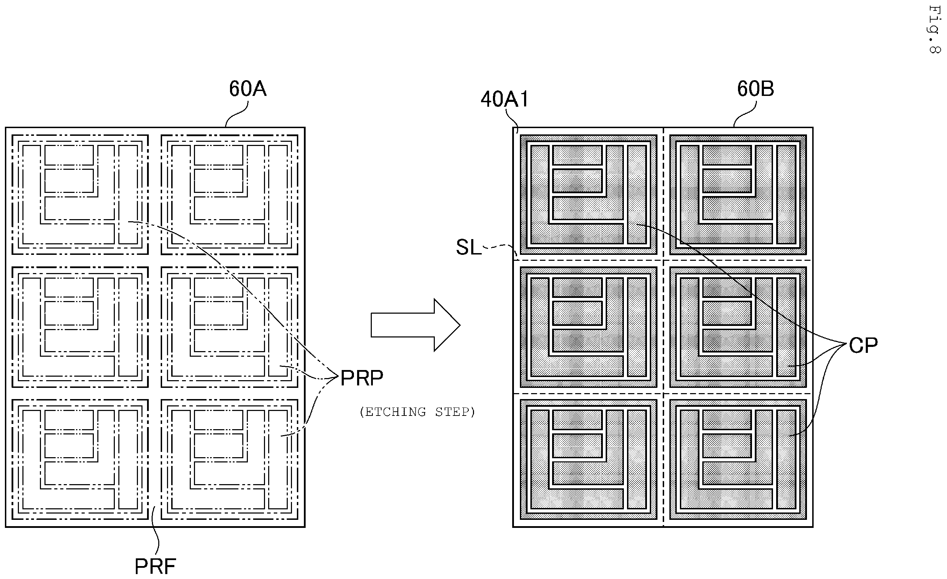

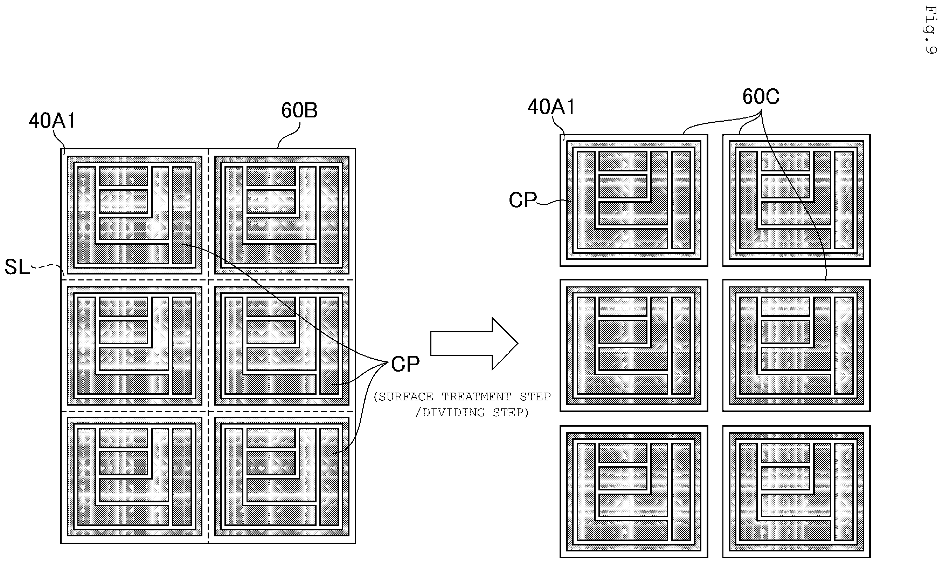

First, a ceramic substrate 40 (refer to Fig. 3A, Fig. 3D, Fig. 3G, Fig. 3J, Fig. 3M, Fig. 3P, Figs. 3S to 3V, and the like), a motherboard 60 (one example of a composite substrate, refer to Fig. 6A and Fig. 6B), an assembly substrate 60B (another example of the composite substrate, refer to Fig. 8 and Fig. 9), and a circuit substrate 60C (refer to Fig. 9) of the present embodiment will be described.

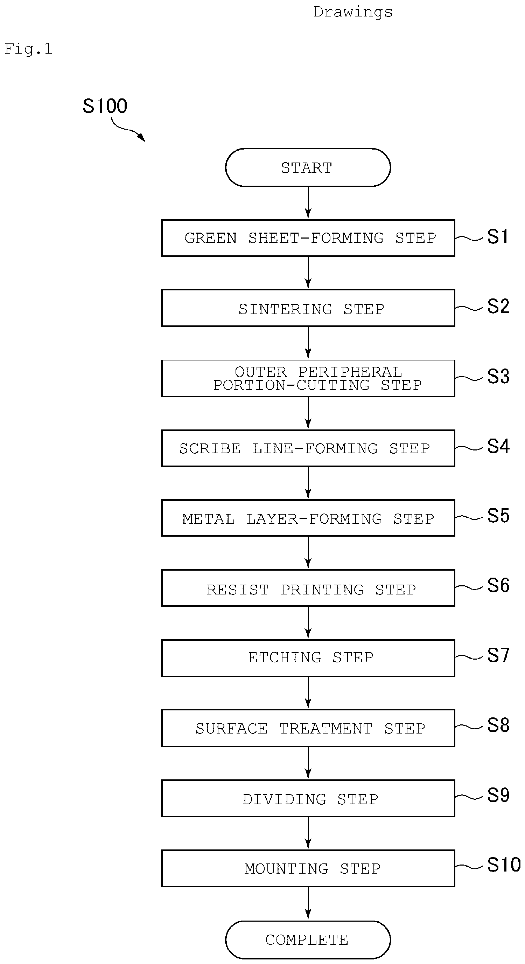

Next, a manufacturing method of a plurality of mounting substrates (not shown) of the present embodiment (refer to Fig. 1) will be described.

Next, the effect of the present embodiment will be described.

Next, a modification example of the present embodiment will be described.

In all of the drawings to be referred to in the following description, the same configuration elements will be given the same reference sign and will not be repeated.

### <<Ceramic substrate>>

First, the ceramic substrate 40 of the present embodiment will be described with reference to Fig. 3D to Fig. 3V.

Here, the ceramic substrate 40 of the present embodiment has a plurality of shape variations. For example, the ceramic substrate 40 as a first example (refer to Fig. 3D), the ceramic substrate 40 as a second example (refer to Fig. 3G), the ceramic substrate 40 as a third example (refer to Fig. 3J), the ceramic substrate 40 as a fourth example (refer to Fig. 3M), the ceramic substrate 40 as a fifth example (refer to Fig. 3P), a sixth ceramic substrate 40 (refer to Figs. 3S to 3V), and the like. The ceramic substrates 40 in all of the examples have a rectangular shape in a plan view.

In addition, the ceramic substrate 40 of the present embodiment has the following basic features.

Specifically, the basic features of the ceramic substrate 40 of the present embodiment are that "the ceramic substrate 40 having a rectangular shape in a plan view, in which, at a location deviating from an intersection formed by a pair of diagonal lines of the ceramic substrate, at least one convex portion that is convex toward one side or the other side in a sheet thickness direction is formed, and a value obtained by dividing a maximum projection amount of the at least one convex portion by a length of the diagonal line of the ceramic substrate 40 is equal to or less than 2 pm/mm". In addition, as the ceramic substrate 40 having these basic features, there are the ceramic substrate 40 as the first example (refer to Fig. 3D), the ceramic substrate 40 as the second example (refer to Fig. 3G), the ceramic substrate 40 as the third example (refer to Fig. 3J), the ceramic substrate 40 as the fourth example (refer to Fig. 3M), the ceramic substrate 40 as the fifth example (refer to Fig. 3P), and the sixth ceramic substrate 40 (refer to Figs. 3S to 3V).

In addition, the ceramic substrate 40 of the present embodiment may be aspects as described below as long as the above-described basic features are satisfied.

For example, in one aspect of the ceramic substrate 40 of the present embodiment, the at least one convex portion is a plurality of convex portions, and the plurality of convex portions may be formed in two regions partitioned by one diagonal line of the pair of diagonal lines of the ceramic substrate 40, respectively. In addition, as the ceramic substrate 40 of this aspect, there are the ceramic substrate 40 as the first example (refer to Fig. 3D), the ceramic substrate 40 as the second example (refer to Fig. 3G), the ceramic substrate 40 as the third example (refer to Fig. 3J), and the ceramic substrate 40 as the fourth example (refer to Fig. 3M).

In addition, for example, in one aspect of the ceramic substrate 40 of the present embodiment, the at least one convex portion is a plurality of convex portions, and the plurality of convex portions may be formed in four regions partitioned by the pair of diagonal lines of the ceramic substrate 40, respectively. In addition, as the ceramic substrate 40 of this aspect, there is the ceramic substrate 40 as the fourth example (refer to Fig. 3M) .

In addition, for example, in one aspect of the ceramic substrate 40 of the present embodiment, the at least one convex portion is a plurality of convex portions, a part of the plurality of convex portions may be formed to become convex toward one side in the sheet thickness direction, and the remaining part of the plurality of convex portions may be formed to become convex toward the other side in the sheet thickness direction. In addition, as the ceramic substrate 40 of this aspect, there are the ceramic substrate 40 as the first example (refer to Fig. 3D), the ceramic substrate 40 as the fourth example (refer to Fig. 3M), and the ceramic substrate 40 as the fifth example (refer to Fig. 3P).

Next, examples of the ceramic substrate 40 will be described with reference to Fig. 3D to Fig. 3W using the first example to sixth example. In these examples, a front surface 40A1 of the ceramic substrate 40 is a substantially flat surface which may be slightly uneven. The ceramic substrate 40 is not limited to these examples, and the front surface 40A1 of the ceramic substrate 40 may be a completely flat surface having no convex portions.

In addition, the first to sixth examples to described below are merely examples of the ceramic substrate 40 of the present embodiment and are included in the ceramic substrate 40 of the present embodiment as long as the examples are ceramic substrates having the above-described basic features.

### [Ceramic substrate as first example]

The ceramic substrate 40 as the first example will be described with reference to Fig. 3D to Fig. 3F.

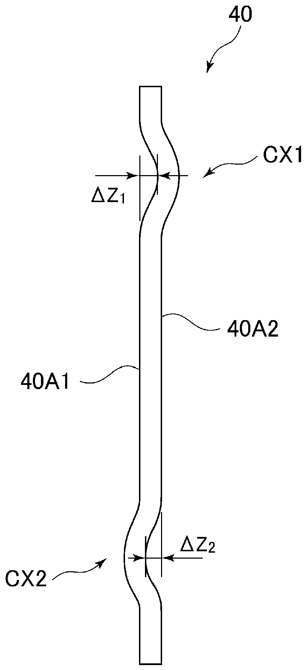

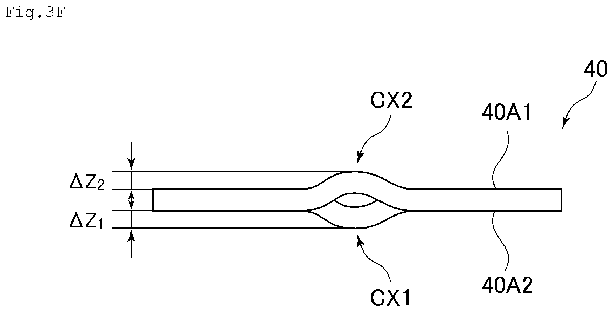

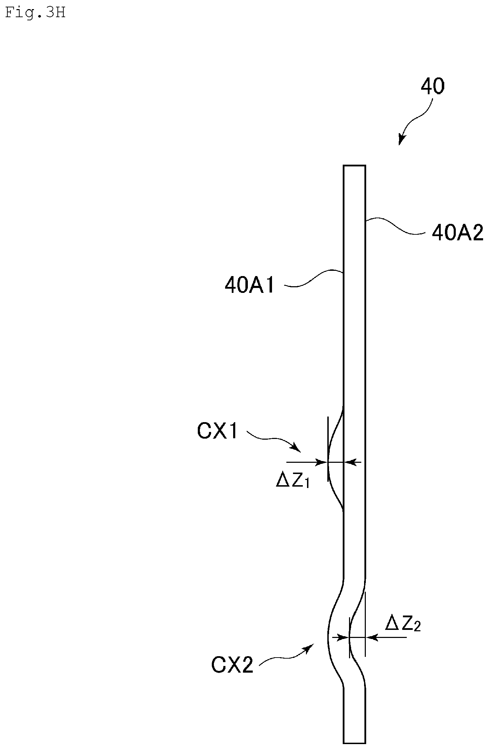

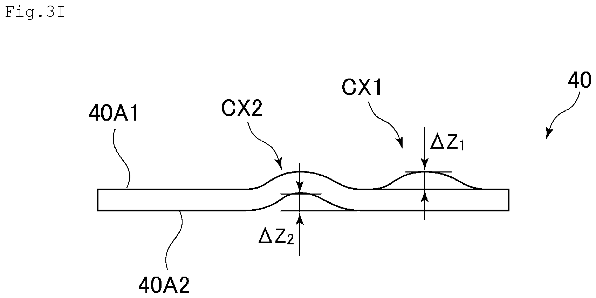

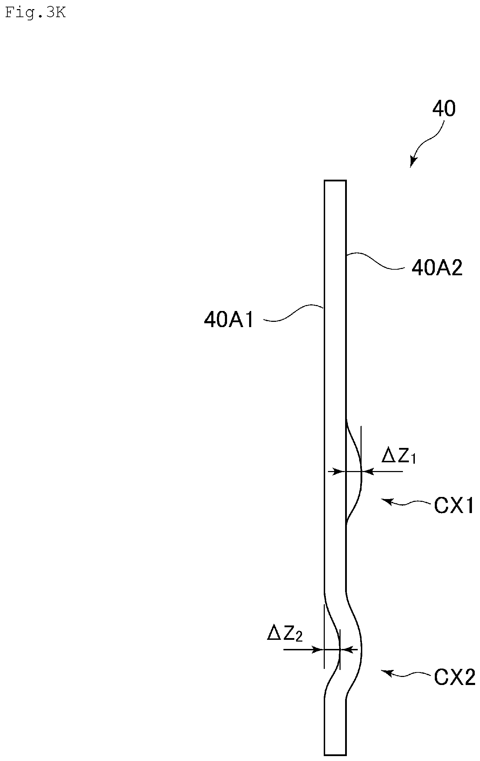

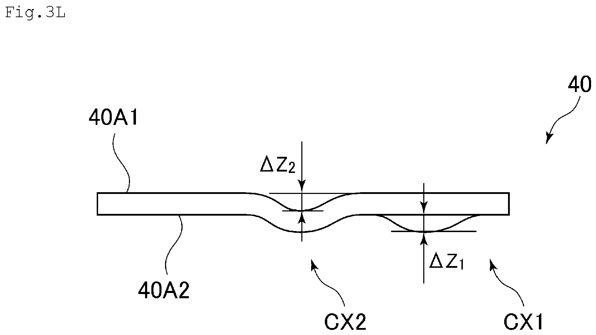

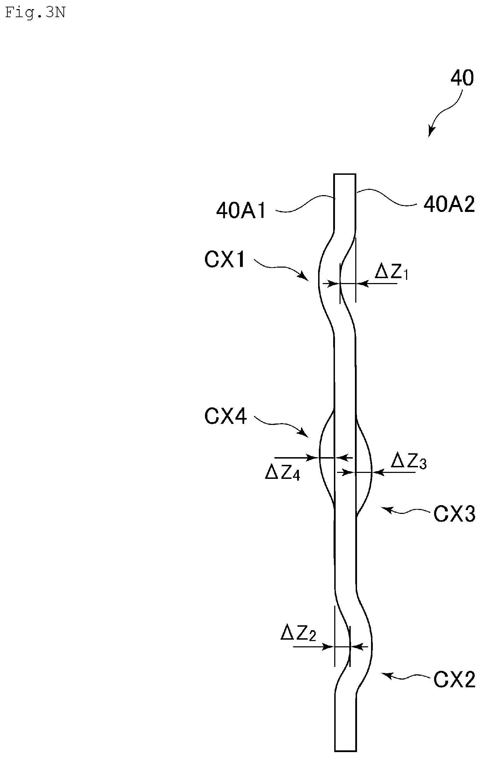

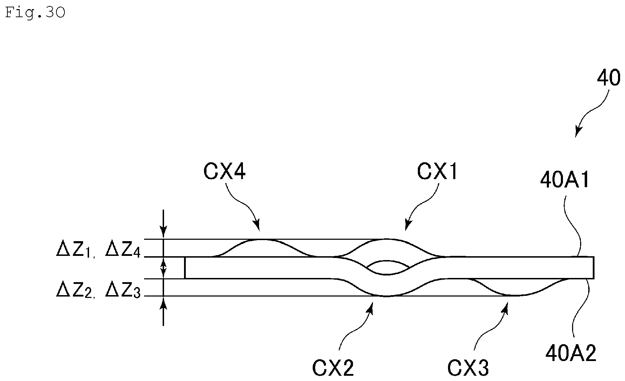

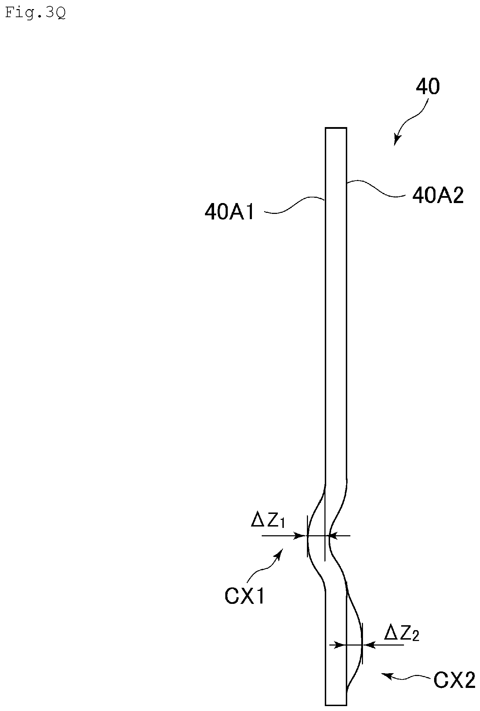

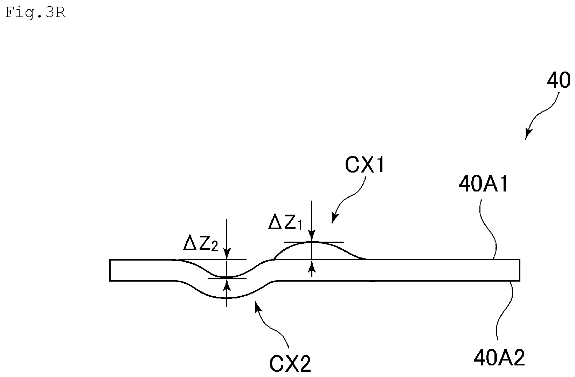

Here, Fig. 3D is a plan view of the ceramic substrate 40 as the first example of the present embodiment and a high/low distribution map with a high/low degree (concave condition) profile in the sheet thickness direction (Z direction) attached thereto. Fig. 3E is a cross-sectional view (end face view) of the ceramic substrate 40 as the first example and a cross-sectional view of the ceramic substrate 40 as the first example cut along an A-A cutting line in Fig. 3D. Fig. 3F is a cross-sectional view of the ceramic substrate 40 as the first example and a cross-sectional view of the ceramic substrate 40 as the first example cut along a B-B cutting line in Fig. 3D. In Fig. 3F, originally, a convex portion CX1 is not expressed as a cut surface, but the convex portion CX1 is shown in a state of being cut by a cut surface parallel to the B-B cutting line so as to facilitate the understanding of the relationship with a convex portion CX2. In addition, also in cross-sectional views relating to the second to fifth examples (Figs. 3H, 3I, 3K, 3L, 3N, 3O, 3Q, and 3R) as well, in a cross-sectional view (end face view) showing the cut surface of a certain convex portion among the plurality of convex portions, the other convex portion is shown in a state of, similarly, being cut by a parallel cut surface so as to facilitate the understanding of the relationship with the other convex portion in terms of the projection amount (or the concave amount) .

The ceramic substrate 40 as the first example is not flat in the sheet thickness direction (Z direction) and is in a warped state. In addition, the ceramic substrate 40 as the first example has the above-described basic characteristics and, furthermore, has features as described below.

### (First feature)

A first feature is that, in a plan view, at a location deviating from the intersection O formed by the pair of diagonal lines (the pair of broken lines in Fig. 3D), at least one convex portion (the convex portion CX1 or CX2 in the case of the first example) that is convex toward one side or the other side in the sheet thickness direction (Z direction) is formed, and the warpage amount is equal to or less than 2 pm/mm.

Here, the warpage amount in the present specification refers to a value obtained by dividing the maximum projection amount in the sheet thickness direction of the ceramic substrate 40 by the length of the diagonal line of the ceramic substrate 40.

As an example, the ceramic substrates 40 as the first example to the sixth example have a length of 206 mm and a width of 146 mm, and thus the length of the diagonal line is about 252.5 mm. In addition, the projection amounts of the convex portions CX1 and CX2 (the amount of a portion that becomes a convex shape or a concave shape compared with a case where the portion is flat (the reference in the drawing)) are defined as ΔZ₁ and ΔZ₂. In addition, the projection amounts ΔZ₁ and ΔZ₂ are each equal to or less than 420 um as an example. That is, in the case of the first example, the maximum projection amount is equal to or less than 420 um. From what has been described above, the warpage amount of the ceramic substrate 40 as the first example becomes equal to or less than 2 µm/mm.

Here, the "maximum projection amount" in the present specification means the maximum value of the amounts of portions that becomes a convex shape or a concave shape compared with a case where the portions are flat and will be described in detail in the description of the ceramic substrate 40 as the sixth example to be described below.

### (Second feature)

A second feature is based on the premise of the first feature and is that the plurality of convex portions (the convex portions CX1 and CX2 in the first example) are formed in two regions partitioned by one diagonal line (both diagonal lines in the first example) of the pair of diagonal lines of the ceramic substrate 40, respectively.

### (Third feature)

A third feature is based on the premise of the first feature and is that a part (one of the convex portions CX1 and CX2) of the plurality of convex portions (the convex portions CX1 and CX2 in the first example) is formed to become convex toward one side in the sheet thickness direction (Z direction), and the remaining part (the other of the convex portions CX1 and CX2) is formed to become convex toward the other side in the sheet thickness direction.

Hitherto, the first example of the ceramic substrate 40 has been described.

### [Ceramic substrate as second example]

The ceramic substrate 40 as the second example will be described with reference to Fig. 3G to Fig. 3I.

Here, Fig. 3G is a plan view of the ceramic substrate 40 as the second example of the present embodiment and a high/low distribution map with a high/low degree (concave condition) profile in the sheet thickness direction (Z direction) attached thereto. Fig. 3H is a cross-sectional view (end face view) of the ceramic substrate 40 as the second example and a cross-sectional view of the ceramic substrate 40 as the second example cut along an A-A cutting line in Fig. 3G. Fig. 3I is a cross-sectional view (end face view) of the ceramic substrate 40 as the second example and a cross-sectional view of the ceramic substrate 40 as the second example cut along a B-B cutting line in Fig. 3G.

The ceramic substrate 40 as the second example has, similar to the ceramic substrate 40 as the first example (refer to Fig. 3D to Fig. 3F), a substantially flat surface although the surface is slightly uneven. In addition, the ceramic substrate 40 as the second example has the first feature and the second feature. However, the convex portions CX1 and CX2 of the second example both become convex toward one side (toward the front surface 40A1 side) in the sheet thickness direction (Z direction), which is different from the case of the first example (refer to Fig. 3D) .

Hitherto, the second example of the ceramic substrate 40 has been described.

### [Ceramic substrate as third example]

The ceramic substrate 40 as the third example will be described with reference to Fig. 3J to Fig. 3L.

Here, Fig. 3J is a plan view of the ceramic substrate 40 as the third example of the present embodiment and a high/low distribution map with a high/low degree (concave condition) profile in the sheet thickness direction (Z direction) attached thereto. Fig. 3K is a cross-sectional view (end face view) of the ceramic substrate 40 as the third example and a cross-sectional view of the ceramic substrate 40 as the third example cut along an A-A cutting line in Fig. 3J. Fig. 3L is a cross-sectional view (end face view) of the ceramic substrate 40 as the third example and a cross-sectional view of the ceramic substrate 40 as the third example cut along a B-B cutting line in Fig. 3J.

The ceramic substrate 40 as the third example has, similar to the ceramic substrate 40 as the first example (refer to Fig. 3D to Fig. 3F) and the ceramic substrate 40 as the second example (refer to Fig. 3G to Fig. 3I), a substantially flat surface although the surface is slightly uneven. In addition, the ceramic substrate 40 as the third example has the first feature and the second feature. However, the convex portions CX1 and CX2 of the third example each become convex toward the other side (toward the rear surface 40A2 side) in the sheet thickness direction (Z direction), which is different from the case of the second example (refer to Fig. 3G).

Hitherto, the third example of the ceramic substrate 40 has been described.

### [Ceramic substrate as fourth example]

The ceramic substrate 40 as the fourth example will be described with reference to Fig. 3M to Fig. 3O.

Here, Fig. 3M is a plan view of the ceramic substrate 40 as the fourth example of the present embodiment and a high/low distribution map with a high/low degree (concave condition) profile in the sheet thickness direction (Z direction) attached thereto. Fig. 3N is a cross-sectional view (end face view) of the ceramic substrate 40 as the fourth example and a cross-sectional view of the ceramic substrate 40 as the fourth example cut along an A-A cutting line in Fig. 3M. Fig. 3N is a cross-sectional view (end face view) of the ceramic substrate 40 as the fourth example and a cross-sectional view of the ceramic substrate 40 as the fourth example cut along a B-B cutting line in Fig. 3M.

The ceramic substrate 40 as the fourth example has, similar to the ceramic substrate 40 as the first example (refer to Fig. 3D to Fig. 3F), the ceramic substrate 40 as the second example (refer to Fig. 3G to Fig. 3I), and the ceramic substrate 40 as the third example (refer to Fig. 3J to Fig. 3L), a substantially flat surface although the surface is slightly uneven. In addition, the ceramic substrate 40 as the fourth example has the first feature, the second feature, the third feature, and a fourth feature to be described below.

The projection amounts ΔZ₃ and ΔZ₄ of the convex portions CX3 and CX4 in the fourth example are equal to or less than 1260 um as an example.

### (Fourth feature)

A fourth feature is based on the premise of the first feature and is that the plurality of convex portions (the convex portions CX1, CX2, CX3, and CX4 in the fourth example) are formed in four regions partitioned by the pair of diagonal lines of the ceramic substrate 40, respectively.

Hitherto, the fourth example of the ceramic substrate 40 has been described.

### [Ceramic substrate as fifth example]

The ceramic substrate 40 as the fifth example will be described with reference to Fig. 3P to Fig. 3R.

Here, Fig. 3P is a plan view of the ceramic substrate 40 as the fifth example of the present embodiment and a high/low distribution map with a high/low degree (concave condition) profile in the sheet thickness direction (Z direction) attached thereto. Fig. 3Q is a cross-sectional view (end face view) of the ceramic substrate 40 as the fifth example and a cross-sectional view of the ceramic substrate 40 as the fifth example cut along an A-A cutting line in Fig. 3P. Fig. 3R is a cross-sectional view (end face view) of the ceramic substrate 40 as the fifth example and a cross-sectional view of the ceramic substrate 40 as the fifth example cut along a B-B cutting line in Fig. 3P.

The ceramic substrate 40 as the fifth example has, similar to the ceramic substrate 40 as the first example (refer to Fig. 3D to Fig. 3F), the ceramic substrate 40 as the second example (refer to Fig. 3G to Fig. 3I), the ceramic substrate 40 as the third example (refer to Fig. 3J to Fig. 3L), and the ceramic substrate 40 as the fourth example (refer to Fig. 3M to Fig. 3O), a substantially flat surface although the surface is slightly uneven. In addition, the ceramic substrate 40 as the fifth example has the first feature and the third feature. However, the convex portions CX1 and CX2 of the second example are each formed in one of the four regions partitioned by the pair of diagonal lines of the ceramic substrate 40, respectively, which is different from the case of the first example (refer to Fig. 3D) .

Hitherto, the fifth example of the ceramic substrate 40 has been described.

### [Ceramic substrate as sixth example]

The ceramic substrate 40 as the sixth example will be described with reference to Fig. 3S to Fig. 3W.

Here, Fig. 3S to Fig. 3V are each a plan view of the ceramic substrate 40 as the sixth example of the present embodiment and a high/low distribution map with a high/low degree (concave condition) profile in the sheet thickness direction (Z direction) attached thereto. In Fig. 3S to Fig. 3V, measurement spans at the time of measuring the warpage amount to be described below are different, respectively (in the order of 70 µm, 100 µm, 200 µm, and 300 um, respectively).

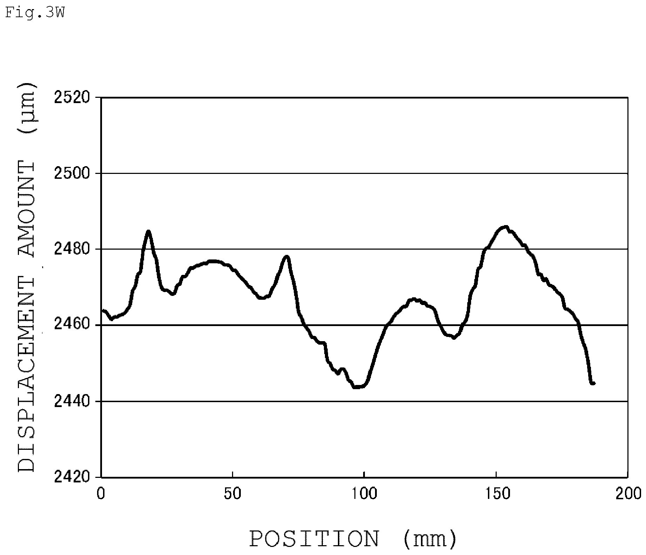

Fig. 3W is a graph showing a displacement amount distribution measured along a laser three-dimensional shape measuring instrument along C-C straight lines in Fig. 3S to Fig. 3V.

As shown in Fig. 3S to Fig. 3V, the shapes are irregular and uneven. This irregular unevenness is a minute unevenness. In a case where a range of 0 mm to 200 mm is observed at random 5 visual fields, the difference between the maximum displacement amount and the minimum displacement amount is equal to or less than 100 um.

In addition, in a case where the range of 0 mm to 200 mm is observed at random 5 visual fields, a plurality of convex portions may be observed in all of the visual fields. The convex portion mentioned herein refers to a portion that is equal to or more than 10 um different in the displacement amount from, between the adjacent concave portions, a concave portion having a large displacement amount, and, in Fig. 3W, there are 5 convex portions. From the viewpoint of including the entire width (200 mm in Fig. 3W) in the observation at five visual fields, the width of one visual field is equal to or more than 40 mm and preferably equal to or more than 100 mm.

Here, in the present embodiment, the warpage amount of the ceramic substrate 40 was measured as described below. That is, a laser beam was radiated from to a laser three-dimensional shape measuring instrument to the ceramic substrate 40, light diffused and reflected from the ceramic substrate 40 was received to calculate the displacement amount, and the warpage amount of the main surface of the ceramic substrate 40 was measured. Here, the laser three-dimensional shape measuring instrument adopts K2-300 (manufactured by Kohzu Precision Co., Ltd.) as an XYθ stage unit, LK-G500 (manufactured by Keyence Corporation) as a high-precision laser displacement meter, and SC-200K (manufactured by Kohzu Precision Co., Ltd.) as a motor controller, and DL-100 (manufactured by Kohzu Precision Co., Ltd.) as an AD converter. In this case, the measurement pitches were set to 1.0 mm.

In addition, the "maximum projection amount" in the present embodiment refers to the maximum displacement amount (the magnitude of the maximum projection amount or concave amount) obtained when the front surface 40A1 (or the rear surface 40A2), which becomes a reference, is calculated from displacements measured with the laser three-dimensional shape measuring instrument and displacement amounts from the reference surface are calculated.

Hitherto, the sixth example of the ceramic substrate 40 has been described.

Hitherto, the features of the first to sixth examples of the ceramic substrate 40 have been described.

In the case of the ceramic substrate 40 as the first example (refer to Fig. 3D), the convex portions CX1 and CX2 are formed in the two regions partitioned on both sides of the intersection O in the longitudinal direction (Y direction) among the four regions partitioned by the pair of diagonal lines of the ceramic substrate 40; however, as a different aspect of the ceramic substrate 40 of the present embodiment, for example, the convex portions CX1 and CX2 may be formed in the two regions partitioned on both sides of the intersection O in the lateral direction (X direction).

In addition, in the case of the ceramic substrate 40 as the fourth example (refer to Fig. 3M), the convex portions CX2 and CX3 become convex toward the rear surface 40A2 side in the sheet thickness direction (Z direction) of the ceramic substrate 40 (refer to Fig. 3N and Fig. 3O); however, as a different aspect of the ceramic substrate 40 of the present embodiment, for example, one or both of the convex portions CX2 and CX3 may become convex toward the front surface 40A1 side.

In addition, for example, the ceramic substrate may be a ceramic substrate (not shown) obtained by combining the convex portion CX2 (refer to Fig. 3P) of the ceramic substrate 40 as the fifth example to the ceramic substrate 40 as the first example (refer to Fig. 3D).

In addition, for example, the ceramic substrate may be the ceramic substrate 40 as the first example (refer to Fig. 3D) in which any one of the convex portions CX1 and CX2 is not provided (not shown) . Similarly, the ceramic substrate may be the ceramic substrate 40 as the fifth example (refer to Fig. 3P) in which any one of the convex portions CX1 and CX2 is not provided (not shown) .

As described above, the ceramic substrate 40 of the present embodiment needs to have the above-described basic features.

Hitherto, the ceramic substrate 40 of the present embodiment has been described.

### <<Motherboard>>

Next, the motherboard 60 of the present embodiment will be described with reference to Fig. 6A and Fig. 6B.

The motherboard 60 of the present embodiment includes the ceramic substrate 40, a first metal layer 50A fixed to a front surface 40A1 side of the ceramic substrate 40, and a second metal layer 50B fixed to a rear surface 40A2 side of the ceramic substrate 40.

The motherboard 60 of Fig. 6A and Fig. 6B may include an SL-drawn ceramic substrate 40A to be described below instead of the ceramic substrate 40. As described below, the SL-drawn ceramic substrate 40A is a substrate obtained by forming a plurality of scribe lines SL on the ceramic substrate 40 as an example.

Hitherto, the motherboard 60 of the present embodiment has been described.

### <<Circuit substrate>>

Next, the circuit substrate 60C of the present embodiment will be described with reference to Fig. 9.

The circuit substrate 60C of the present embodiment includes the ceramic substrate 40, a circuit pattern CP formed on the front surface 40A1 side of the ceramic substrate 40, and a metal layer (second metal layer 50B) fixed to the rear surface 40A2 side of the ceramic substrate 40.

Hitherto, the circuit substrate 60C of the present embodiment has been described.

### <<Manufacturing method of plurality of mounting substrates of present embodiment>>

Next, a manufacturing method S100 of a plurality of mounting substrates of the present embodiment (hereinafter, referred to as the manufacturing method S100 of the present embodiment) will be described with reference to Fig. 1 and the like.

As shown in Fig. 1, the manufacturing method S100 of the present embodiment includes a green sheet-forming step S1, a sintering step S2, an outer peripheral portion-cutting step S3, a scribe line-forming step S4 (hereinafter, referred to as SL forming step S4), and a metal layer-forming step S5, a resist printing step S6, an etching step S7, a surface treatment step S8, a dividing step S9, and a mounting step S10. In addition, in the manufacturing method S100 of the present embodiment, the individual steps are performed in the described order.

The relationships between the times where the individual steps are completed in the manufacturing method S100 of the present embodiment and products at those times are as described below.

| **Each step upon completion** | **product at that time** |
|---|---|
| Sintering step S2 | Ceramic substrate 40 (refer to Fig. 3D) |
| SL forming step S4 | SL-drawn ceramic substrate 40A (refer to Fig. 5 |
| Metal layer-forming step S5 | Motherboard 60 (refer to Fig. 6A and Fig. 6B) |
| Etching step S7 | Assembly substrate 60B (refer to Fig. 8) |
| Dividing step S9 | Plurality of circuit substrates 60C (refer to Fig. 9) |
| Mounting step S10 | Plurality of mounting substrates |

In addition, the description of each step of the manufacturing method S100 of the present embodiment includes the description of each of the following inventions.

### (Invention relating to a manufacturing method of ceramic substrate)

A manufacturing method of the ceramic substrate 40 of the present embodiment includes a cutting step of cutting the strip-shaped green sheet 20 containing the ceramic powder to obtain the individual green sheet 30 and a sintering step of disposing the individual green sheet 30 in a firing chamber, heating the inside of the firing chamber until the temperature in the firing chamber reaches at least equal to or higher than 1600°C, then, cooling the inside of the firing chamber, and sintering the individual green sheet 30 to obtain the ceramic substrate 40, and
in the sintering step, the temperature in the firing chamber is rapidly cooled in a case where the temperature in the firing chamber during the cooling of the inside of the firing chamber reaches a temperature of equal to or lower than 650°C (refer to Fig. 1, Fig. 2B, Fig. 2C, Fig. 3B, and the like).

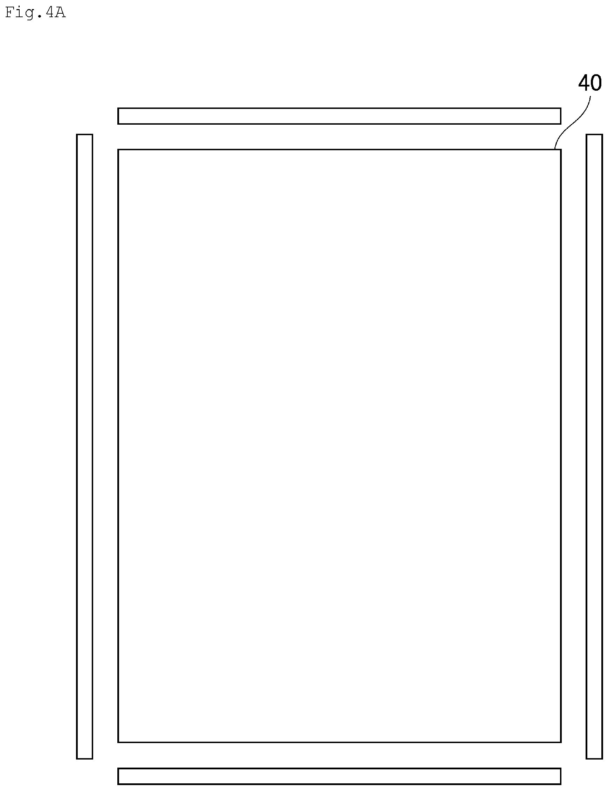

Furthermore, the manufacturing method of the ceramic substrate 40 of the present embodiment includes a cutting step of cutting portions on the entire peripheral edge sides of the ceramic substrate 40 cooled after the sintering step (refer to Fig. 1 and Fig. 4A).

### (Invention relating to manufacturing method of motherboard)

A manufacturing method of the motherboard 60 of the present embodiment includes the manufacturing method of the ceramic substrate and a fixing step of fixing the first metal layer 50A to the front surface 40A1 side of the ceramic substrate 40 and fixing the second metal layer 50B to the rear surface 40A2 side (refer to Fig. 6A).

### (Invention relating to manufacturing method of circuit substrate)

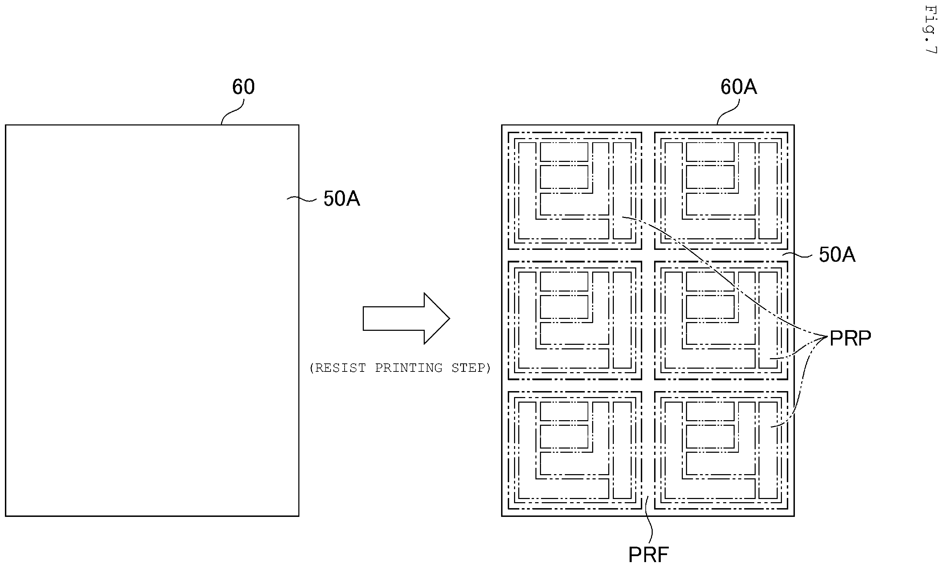

A manufacturing method of the circuit substrate 60C of the present embodiment includes the manufacturing method of the motherboard 60 and a pattern-forming step of forming at least one circuit pattern CP on at least one of the first metal layer 50A and the second metal layer 50B (in the case of the present embodiment, the first metal layer 50A as an example) (refer to Fig. 7, Fig. 8, and the like).

### (Manufacturing method of plurality of circuit substrates)

A manufacturing method of a plurality of the circuit substrates 60C of the present embodiment includes the manufacturing method of the motherboard 60, a pattern-forming step of forming a plurality of circuit patterns CP on any one of the first metal layer 50A and the second metal layer 50B (in the case of the present embodiment, the first metal layer 50A as an example), and a dividing step of dividing the motherboard 60 on which the plurality of circuit patterns CP have been formed into a plurality of the circuit substrates 60C each including one circuit pattern CP (refer to Fig. 7 to Fig. 9 and the like).

Hereinafter, each step will be described.

### <Green sheet-forming step and sintering step>

A step of performing a green sheet-forming step S1 and a sintering step S2 in the present embodiment in combination in the described order corresponds to the manufacturing method of the ceramic substrate 40.

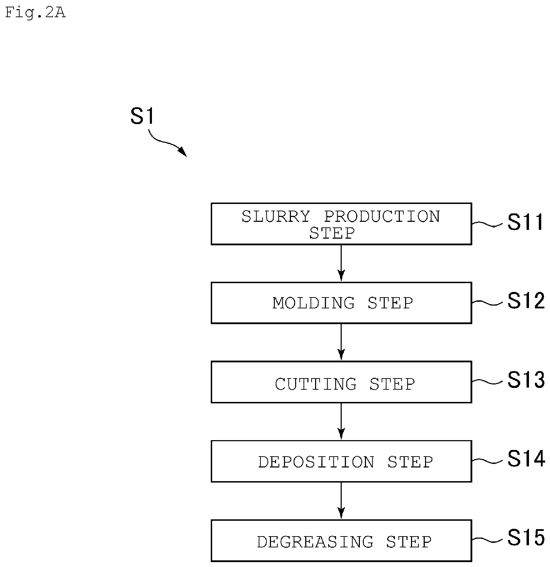

Hereinafter, the manufacturing method of the ceramic substrate 40 of the present embodiment will be described with reference to Fig. 2A to Fig. 2D, Fig. 3A to Fig. 3R, and Fig. 4A and Fig. 4B.

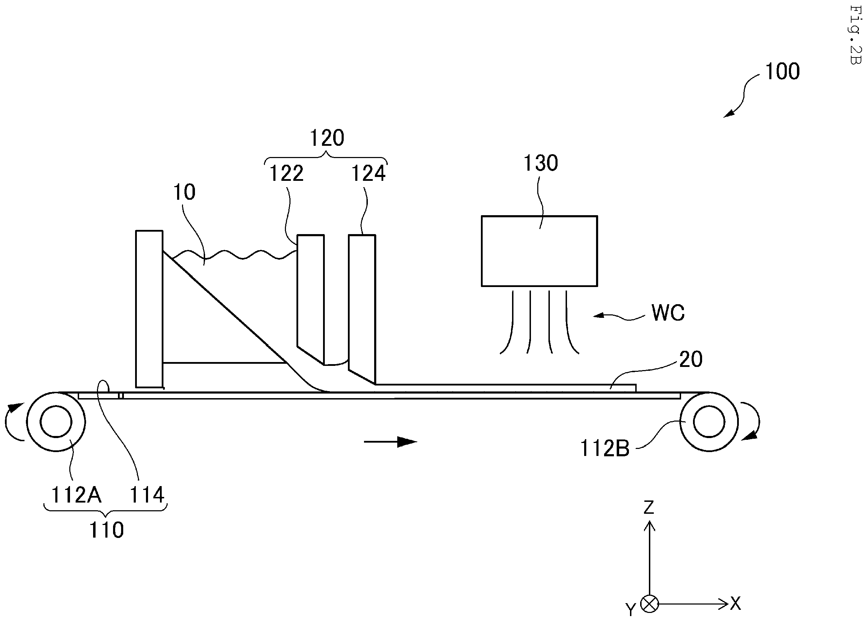

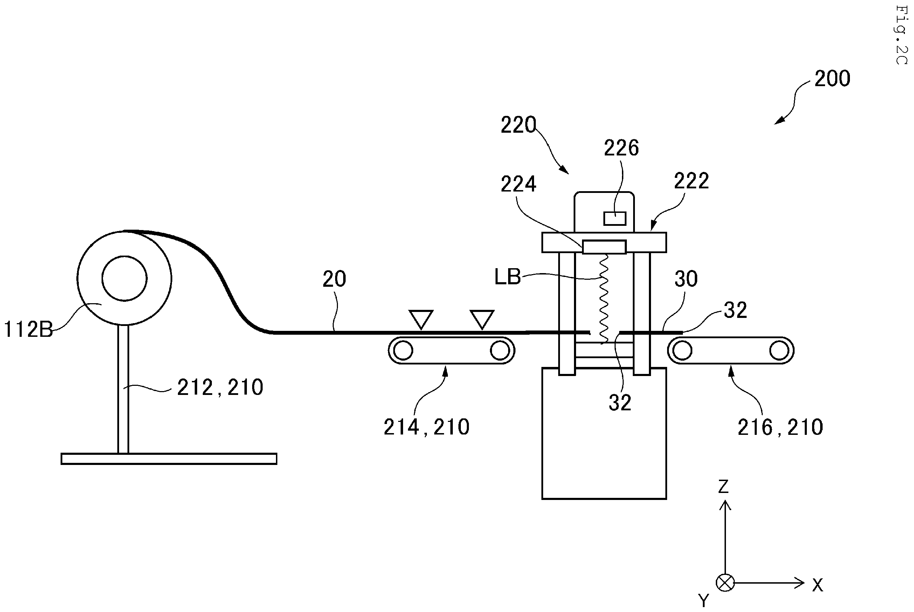

Here, the ceramic substrate 40 is, as an example, a ceramic substrate including a circuit substrate for a power module or a mounting substrate that is mounted in electric vehicles, railroad vehicles, and other industrial equipment. As an example, the ceramic substrate 40 is obtained by sintering the individual green sheets 30 (refer to Fig. 2C) to be described below in a laminated state (refer to Fig. 3A). In addition, the individual green sheets 30 are obtained by cutting the strip-shaped green sheet 20 (refer to Fig. 2B and Fig. 2C). That is, the relationship between the ceramic substrate 40 and the individual green sheet 30 has a relationship between a finished article and an intermediate article (an article manufactured by the steps before the finished article is produced) or a relationship between a first intermediate article and a second intermediate article (an article manufactured by the steps before the first intermediate article is produced). Therefore, the individual green sheet 30 of the present embodiment is manufactured by the steps up to an intermediate stage of the manufacturing method of the ceramic substrate 40 of the present embodiment.

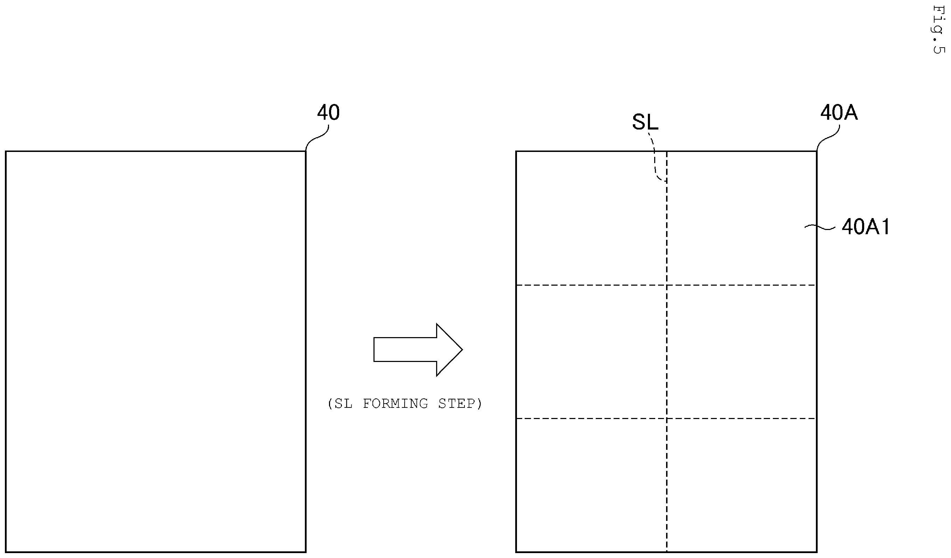

The ceramic substrate 40 of the present embodiment is, as an example, a rectangular sheet (refer to Fig. 3D, Fig. 3G, Fig. 3J, Fig. 3M, Fig. 3P, Fig. 5, and the like).

### <Green sheet-forming step>

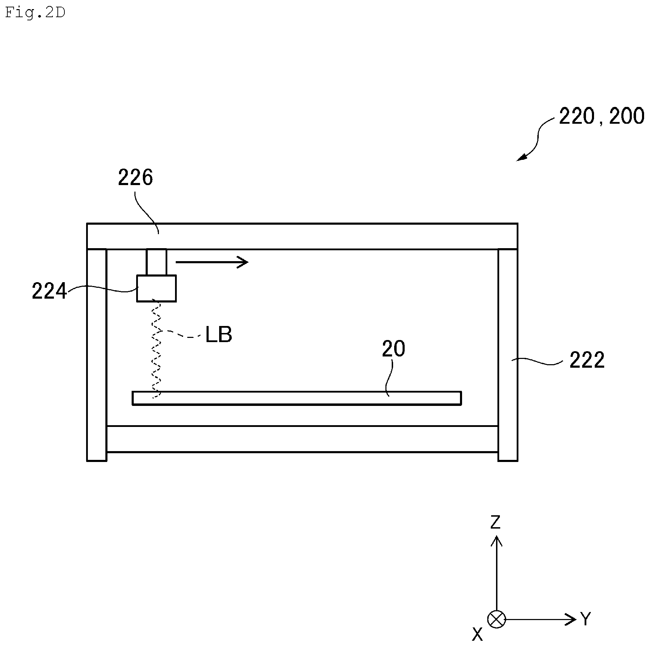

Hereinafter, the green sheet-forming step S1 will be described with reference to Fig. 2A, Fig. 2B, Fig. 2C, and Fig. 2D. The green sheet-forming step S1 of the present embodiment includes a slurry production step S11, a molding step S12, a cutting step S13, a deposition step S14, and a degreasing step S15 and is performed in the described order (refer to Fig. 1 and Fig. 2A) .

### [Slurry production step]

The slurry production step S11 will be described. The present step is a step of mixing a raw material powder to be described below and an organic solvent to prepare a slurry 10. The slurry 10 produced in the present step (refer to Fig. 2B) is molded into a strip-shaped green sheet 20 in the next step (molding step S12).

The raw material powder for the slurry 10 is a powder containing a main component to be described below and a sintering aid. The main component is, as an example, 80% by weight to 98.3% by mass of silicon nitride (Si₃N₄), and the sintering aid is, as an example, 1% by weight to 10% by mass (oxide equivalent) of at least one rare earth element and 0.7% by weight to 10% by mass (oxide equivalent) of magnesium (Mg). The gelatinization rate of a silicon nitride powder is preferably 20% to 100% in consideration of the density, bending strength, and thermal conductivity of the ceramic substrate 40.

Here, as the supplementation of the meaning of "to" used in the present specification, for example, "20% to 100%" means "equal to or more than 20% and equal to or less than 100%". In addition, "-" used in the present specification means "equal to or more than a part described before "to" and equal to or less than a part described after "to".

The reason for setting the proportion of silicon nitride (Si₃N₄) in the raw material powder to 80% by weight to 98.3% by mass as an example is that the bending strength and thermal conductivity of the ceramic substrate 40 to be obtained are not too low, the compactness of the ceramic substrate 40 due to the lack of the sintering aid is ensured, and the like.

Hereinafter, for the sake of simplification of the description, the raw material powder of silicon nitride will be referred to as Si₃N₄ powder (also known as silicon nitride powder and an example of a ceramic powder), the raw material powder of Mg will be referred to as MgO powder, and the powder of rare earth element raw material will be referred to as Y₂O₃ powder. Here, the raw material powder of silicon nitride and the raw material powders of the sintering aid may not be Si₃N₄ powder, MgO powder, and Y₂O₃ powder, respectively.

In addition, the Si₃N₄ powder, the MgO powder, and the Y₂O₃ powder blended as described above are mixed with a plasticizer, an organic binder, and an organic solvent to produce the slurry 10. Therefore, the slurry 10 that is produced in the present step contains the ceramic powder.

Hitherto, the slurry production step S11 has been described.

### [Molding step]

Next, the molding step S12 will be described. As shown in Fig. 2B, the present step is a step of manufacturing the strip-shaped green sheet 20 from the slurry 10.

The present step is performed using, as an example, a doctor blade molding device 100 shown in Fig. 2B. Here, the doctor blade molding device 100 includes a belt transport mechanism 110, a molding unit 120, and a heating unit 130. The belt transport mechanism 110 has an upstream roller 112A, a downstream roller 112B, and a belt 114 and drives the downstream roller 112 to move the belt 114 from the upstream roller 112 to the downstream roller 112 (along the X direction). The molding unit 120 is disposed on the upper side of the belt 114 (on the Z direction side of the belt 114) and faces the belt 114. The molding unit 120 has an accommodation portion 122 that accommodates the slurry 10 and a doctor blade 124.

In addition, the molding unit 120 regulates the slurry 10 that is taken out from the accommodation portion 122 due to its own weight and an adhesive force to the moving belt 114 with the doctor blade 124 to provide the slurry 10 with a sheet shape having a give film thickness as shown in Fig. 2B. The heating unit 130 blows warm air WC to the slurry 10 having a given film thickness on the belt 114 to make the slurry 10 into a sheet (vaporize the organic solvent). As a result, in the molding step S12, a strip-shaped green sheet 20 having a given width (the Y direction in the drawing corresponds to the width direction) is produced from the slurry 10. That is, in the molding step S12, the slurry 10 is made into a strip shape by doctor blade molding to obtain a strip-shaped green sheet 20 containing Si₃N₄ (ceramic) as an example.

As an example, the present step is performed after the slurry 10 produced in the slurry production step S11 is defoamed and the slurry 10 is thickened. In addition, the film thickness of the strip-shaped green sheet 20 produced in the present step is set in consideration of the film thickness of the ceramic substrate 40 that is manufactured in the end. Accordingly, the regulation conditions (the separation distance from the belt 114 and the like) of the doctor blade 124 for regulating the slurry 10 to a given film thickness are also set in consideration of the film thickness of the ceramic substrate 40 that is manufactured in the end.

Hitherto, the molding step S12 has been described.

### [Cutting step]

Next, the cutting step S13 of the strip-shaped green sheet 20 will be described. As shown in Fig. 2C, the present step is a step of cutting the strip-shaped green sheet 20 to manufacture the individual green sheet 30.

The present step is performed using a cutting device 200 shown in Fig. 2C as an example. Here, the cutting device 200 includes a sheet transport mechanism 210 and a cutting portion 220.

The sheet transport mechanism 210 has a support portion 212, a first transport portion 214, and a second transport portion 216. The support portion 212 supports the roller 112B having the strip-shaped green sheet 20 produced in the molding step S12 wound around the outer peripheral surface (refer to Fig. 2B and Fig. 2C) so as to be capable of rotating. The first transport portion 214 adjusts the posture of the strip-shaped green sheet 20 transported from the support portion 212 and transports the strip-shaped green sheet 20 to the cutting portion 220 along the X direction (along the longitudinal direction of the strip-shaped green sheet 20). The second transport portion 216 further transports the individual green sheet 30 produced by cutting the strip-shaped green sheet 20 with the cutting portion 220 downstream (in the X direction).

In addition, the cutting portion 220 has a housing 222, a radiation portion 224, and a moving mechanism 226. The radiation portion 224 radiates a laser beam LB as an example. The moving mechanism 226 causes the radiation portion 224 to scan the strip-shaped green sheet 20 from one end to the other end in the lateral direction (Y direction in the drawing). The radiation portion 224 and the moving mechanism 226 are attached to the housing 222.

In addition, in the cutting device 200 of the present embodiment, the strip-shaped green sheet 20 is transported with the sheet transport mechanism 210 by the length of the individual green sheet 30, the strip-shaped green sheet 20 is stopped, and the strip-shaped green sheet 20 is cut with the cutting portion 220. In this case, the cutting portion 220 causes the radiation portion 224 to radiate the laser beam LB while moving the radiation portion 224 with the moving mechanism 226 along the Y direction from one end side to the other end side in the lateral direction of the strip-shaped green sheet 20 (refer to Fig. 2). In addition, the radiation portion 224 that is scanned with the moving mechanism 226 intermittently radiates the laser beam LB. Here, "intermittently" means repetition of radiating for a certain period of time and not radiating for a certain period of time. Therefore, the moving mechanism 226 causes the radiation portion 224 to scan by causing the radiation portion 224 to repeatedly move and stop (refer to Fig. 2D).

In the present step, the laser beam LB is radiated to the strip-shaped green sheet 20 as described above, thereby cutting the strip-shaped green sheet 20 to obtain the individual green sheet 30. The laser beam LB may be a carbon dioxide laser beam, an infrared laser beam, an ultraviolet laser beam or other laser beams as long as the strip-shaped green sheet 20 can be cut. In addition, in the description of the present step, the strip-shaped green sheet 20 is cut using the cutting device 200 shown in Fig. 2C to manufacture the individual green sheet 30 as an example, but other methods may also be used as long as the individual green sheet 30 can be manufactured from the strip-shaped green sheet 20. For example, the individual green sheet 30 may be manufactured by blanking the strip-shaped green sheet 20 by pressing using a pressing device (not shown).

The ceramic substrate 40 according to the present embodiment is rectangular. In addition, the length of the diagonal line on the front surface of the ceramic substrate 40 is equal to or more than 150 mm, preferably equal to or more than 200 mm, and more preferably equal to or more than 236 mm. The upper limit is not particularly limited and can be set to, for example, equal to or less than 254 mm.

The thickness of the ceramic substrate 40 according to the present embodiment can be set to equal to or more than 0.1 mm and equal to or less than 3.0 mm and is preferably equal to or more than 0.2 mm and equal to or less than 1.2 mm and more preferably equal to or more than 0.25 mm and equal to or less than 0.5 mm.

Hitherto, the cutting step S13 of the strip-shaped green sheet 20 has been described.

### [Deposition step]

Next, the deposition step S14 will be described. As shown in Fig. 3A, the present step is a step of stacking a plurality of the individual green sheets 30 in the thickness direction. The present step is a step for efficiently sintering the individual green sheets 30 in the subsequent step (sintering step S2).

In the present step, as shown in Fig. 3A, the plurality of individual green sheets 30 are deposited with a non-reactive powder layer (not shown) to be described below interposed therebetween. Here, when the number of the individual green sheets 30 to be stacked is small, the number of the sheets that can be treated at one time in a sintering furnace (not shown) in the subsequent sintering step S2 becomes small (the production efficiency becomes low). On the other hand, when the number of the individual green sheets 30 to be stacked is large, it becomes difficult for a binder to be contained in the individual green sheets 30 in the next step (degreasing step S15) to decompose. For the above-described reasons, the number of the individual green sheets 30 to be stacked in the present step is 8 to 100 and preferably 30 to 70.

In addition, the non-reactive powder layer of the present embodiment is, as an example, a boron nitride powder layer (BN powder layer) having a film thickness of about 1 um to 20 um. The BN powder layer has a function of easily separating the ceramic substrate 40 after the next step (sintering step S2). The BN powder layer is applied as a slurry of BN powder to one surface of each individual green sheet 30 by, for example, spraying, brush application, roll coating, screen printing, or the like. The BN powder has a purity of equal to or higher than 85% and preferably has an average particle size of 1 um to 20 µm.

Hitherto, the deposition step S14 has been described.

### [Degreasing step]

Next, the degreasing step S15 will be described. The present step is a step for degreasing the binder and the plasticizer contained in the individual green sheets 30 before the next step (sintering step S2).

In the present step, as an example, the plurality of individual green sheets 30 stacked in the deposition step S14 (refer to Fig. 3A) are held in a temperature environment of 450°C to 750°C for 0.5 hours to 20 hours. As a result, the binder and the plasticizer contained in the plurality of individual green sheets 30 are degreased.

Hitherto, the degreasing step S15 has been described. In addition, the green sheet-forming step S1 of the present embodiment has been thus far described.

### <Sintering step>

Next, the sintering step S2 will be described with reference to Fig. 3A to Fig. 3R. The present step is a step of sintering the plurality of individual green sheets 30 which have been stacked in the deposition step S14 and in which the binder and the plasticizer have been degreased in the degreasing step S15 (hereinafter, referred to as the plurality of individual green sheets 30 in Fig. 3A) using a sintering device (not shown).

The sintering device includes a sintering furnace and a control device. The sintering furnace has a temperature adjustment mechanism, a firing chamber, and a thermometer for measuring the temperature in the firing chamber. The temperature adjustment mechanism has a temperature raising portion for raising the temperature in the firing chamber (as an example, a heater) and a cooling portion for cooling the inside of the firing chamber (as an example, a water cooling pipe) . Then, in the present step, the control device controls the temperature adjustment mechanism such that the temperature in the firing chamber changes according to a temperature following a temperature control program to be described below in a state where the plurality of individual green sheets 30 of Fig. 3A are disposed in the sintering chamber.

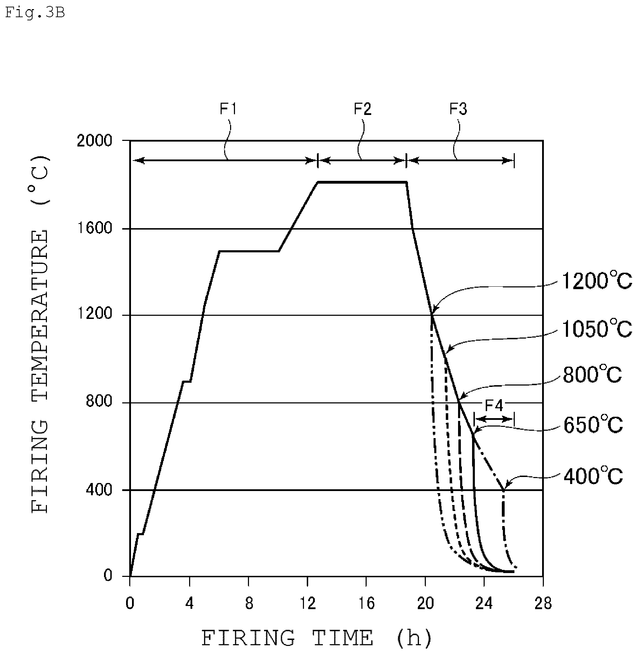

The temperature control program is stored in a storage device (for example, ROM or the like) in the control device. In addition, the temperature control program is a program for the control device to perform a temperature control (for example, a PID control or the like) with the temperature adjustment mechanism while referring to temperature information from the thermometer. Specifically, the temperature control program is a program made up of a temperature raising region F1 having a slow heating region, a temperature holding region F2, and a cooling region F3 and intended to make a temperature profile in the firing chamber follow a profile progressing in the above-described order (refer to Fig. 3B). Hereinafter, the technical meanings of the temperature raising region F1, the temperature holding region F2, and the cooling region F3 will be described.

### [Temperature raising region]

The temperature raising region F1 is a temperature region for the sintering aid contained in each individual green sheet 30 to react with oxide layers on the surfaces of silicon nitride particles to generate a liquid phase. As shown in Fig. 3B, in the temperature raising region F1 of the present embodiment, as an example, the temperature is preferably raised in a stepwise manner from room temperature to a temperature within a range of 1600°C to 2000°C (in the case of the present embodiment, about 1800°C as an example) for 12 hours. In the temperature raising region F1, the grain growth of α-type silicon nitride is suppressed, and the silicon nitride particles are rearranged and densified in the liquefied sintering aid. As a result, after the next temperature holding region F2, the ceramic substrate 40 in which the pore diameters and the porosity are small, the bending strength is strong, and the thermal conductivity is high is obtained. In addition, in order to suppress the decomposition of silicon nitride in a temperature region of equal to or higher than 1200°C, the individual green sheets 30 are preferably fired under nitrogen pressurization (0.8 MPa to 0.9 MPa).

### [Temperature holding region]

The temperature holding region F2 is a temperature region for promoting the rearrangement of silicon nitride particles, the generation of β-type silicon nitride crystals, and the grain growth of silicon nitride crystals from the liquid phase generated in the temperature raising region F1 and further densifying the ceramic substrate 40, which is a sintered body.

Considering the size and aspect ratio (ratio of major axis to minor axis) of β-type silicon nitride particles and the formation of pores due to volatilization of sintering aid, it is preferable that the temperature in the temperature holding region F2 should be in the range of 1600°C to 2000°C and the holding time should be 1 hour to 30 hours (in the case of the present embodiment, about 8 hours as an example). When the temperature in the temperature holding region F2 is lower than 1600°C, it is difficult to densify the ceramic substrate 40. On the other hand, when the temperature of the temperature holding region F2 exceeds 2000°C, the volatilization of the sintering aid and the decomposition of silicon nitride become severe, and the ceramic substrate 40 is difficult to be densified. When the temperature in the temperature holding region F2 is within the range of 1600°C to 2000°C, the temperature in the temperature holding region F2 may be set so as to change with time (for example, the temperature may be set so as to slowly raising the temperature).

Here, the temperature of the temperature holding region F2 is more preferably a temperature within a range of 1750°C to 1950°C and still more preferably a temperature within a range of 1800°C to 1900°C. Furthermore, the temperature of the temperature holding region F2 is preferably equal to or more than 50°C higher and more preferably equal to or more than 100°C to 300°C higher than the upper limit of the temperature of the slow heating region F1. The holding time of the temperature holding region F2 is more preferably 2 hours to 20 hours, still more preferably 3 hours to 10 hours.

### [Cooling region (including rapid cooling region)]

The cooling region F3 is a temperature region for cooling and solidifying the liquid phase maintained in the temperature holding region F2 and fixing the locations of grain boundary phases to be obtained. The cooling region F3 of the present embodiment includes a rapid cooling region F4 to be described below.

The cooling rate of the cooling region F3 is preferably equal to or faster than 100 °C/hour, more preferably equal to or faster than 300 °C/hour, and still more preferably equal to or faster than 500 °C/hour in order to rapidly solidify the liquid phase to maintain the uniformity of the grain boundary phase distribution. A practical cooling rate is preferably 500 °C/hour to 600 °C/hour. The cooling of the liquid phase at a cooling rate as described above suppresses the crystallization of the solidifying sintering aid and forms grain boundary phases mainly containing a glass phase. As a result, it is possible to increase the bending strength of the ceramic substrate 40.

As described above, the cooling region F3 is a temperature region after the temperature raising region F1 and the temperature holding region F2 in the temperature control program (refer to Fig. 3B). Therefore, the cooling region F3 of the present embodiment can be said to be a temperature region in which the inside of the firing chamber is cooled after the temperature in the firing chamber is heated until the inside of the firing chamber reaches at least equal to or higher than 1600°C in the temperature raising region F1 and the temperature holding region F2 (refer to Fig. 3B).

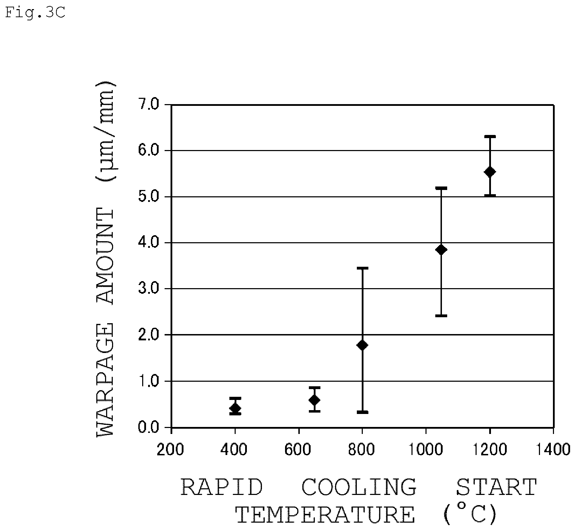

Next, the rapid cooling region F4 will be described with reference to Fig. 3B. The cooling region F3 of the present embodiment has a temperature region in which the cooling temperature rate is further increased in the middle of the progress . In the present embodiment, this "temperature region in which the cooling rate is further increased" is referred to as the rapid cooling region F4. The rapid cooling region F4 of the present embodiment is started in a case where the temperature in the firing chamber reaches any temperature of equal to or lower than 650°C. In the present embodiment, the time for performing the rapid cooling region F4 is, as an example, a time of about equal to or shorter than half of the time for performing the cooling region F3. The technical meaning of setting the rapid cooling region F4 in the cooling region F3 (refer to Fig. 3C to Fig. 3R and the like) will be described below.

When the present step is completed, a plurality of the ceramic substrates 40 are manufactured in a stacked state (refer to Fig. 3A) .

Hitherto, the sintering step S2 has been described.

### <Outer peripheral portion-cutting step (cutting step of ceramic substrate 40)>

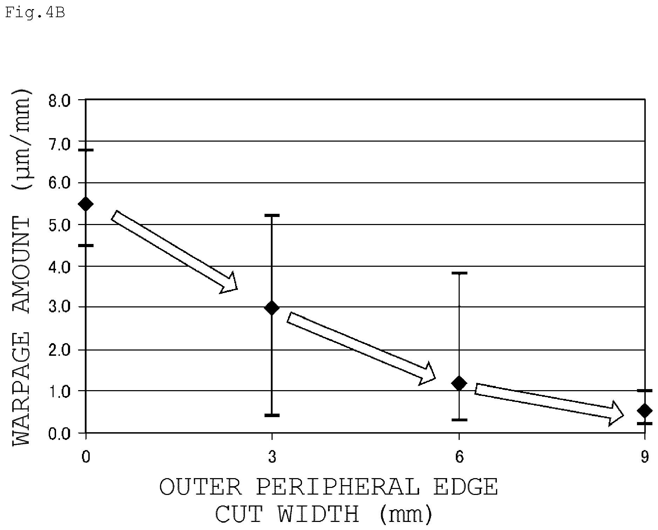

Next, the outer peripheral portion-cutting step S3 will be described with reference to Fig. 4A. The present step is a step (cutting step) of cutting portions on the entire peripheral edge sides of the ceramic substrate 40 manufactured through the sintering step S2. Specifically, in the present step, as an example of the entire peripheral edge sides of the ceramic substrate 40 after the sintering step S2, portions that are equal to or less than 3 mm in width are cut using a laser processing machine (not shown) . In this case, the laser beam source of the laser processing machine intermittently radiates laser beams along the portions to be cut. As a result, a ceramic substrate 40 from which the portions of the entire peripheral edges have been cut is manufactured by the present step. The technical meaning of performing the present step (refer to Fig. 4B) will be described below. In addition, in the present embodiment, the present step is performed by intermittently radiating laser beams using a laser processing machine, but the present step may be performed by a different method as long as the portions of the outer peripheral edges can be cut. For example, the cutting method by the continuous radiation of laser beams may be a cutting method by polishing or a different cutting method.

Hitherto, the outer peripheral portion-cutting step S3 has been described. In addition, the manufacturing method of the ceramic substrate 40 of the present embodiment has been thus far described.

### [Technical meaning of setting rapid cooling region F4 in cooling region F3]

Next, the technical meaning of setting the rapid cooling region F4 in the cooling region F3 will be described with reference to Fig. 3B and Fig. 3C.

Here, Fig. 3B is a graph showing a profile of the firing temperatures in the sintering step S2 (also including conditions studied by a test) . As described above, in the present embodiment, as an example, in a case where the temperature in the firing chamber reaches any temperature of equal to or lower than 650°C, the rapid cooling region F4 is started. Here, as shown by the graph of Fig. 3B, the inventors of the present application performed a test for measuring the warpage amounts of the ceramic substrate 40 in a case where the start temperature of the rapid cooling region F4 (rapid cooling start temperature) was set to 1200°C, 1050°C, 800°C, 650°C, and 400°C. Fig. 3C is a graph of the results, that is, a graph showing the relationship between the rapid cooling start temperatures in the sintering step S2 and the warpage amounts. According to the graph of Fig. 3C, it is found that as the rapid cooling start temperature lowers, the warpage amount of the ceramic substrate 40 tends to decrease. In addition, the warpage amount is, as an example, preferably a maximum of equal to or less than 2 um. The reason therefor is that it becomes possible to easily handle the ceramic substrate 40 at the time of the circuit pattern-forming step (resist printing step S6 and etching step S7) or the electronic component mounting step S10. In addition, as is clear from the graph of Fig. 3C, as the rapid cooling start temperature increases, the warpage amount increases, and the warpage amount further varies. This means that, as the rapid cooling start temperature increases, the influence of a partial strain in the ceramic substrate 40 due to the rapid cooling becomes larger. The inventors of the present application obtained a finding that, in a case where the warpage amount is small, specifically, in a case where the warpage amount is equal to or less than 2 µm, there is a high tendency for the maximum projection amount (the maximum value of the projection amounts or concave amounts) to occur on the outer peripheral sides (that is, the outer peripheral edge portions) of the ceramic substrate 40 having a rectangular shape. In other words, since the circuit pattern is not formed in a predetermined width of the outer peripheral edge portion of the ceramic substrate 40, the influence of the maximum projection amount occurring in the portion becomes small. That is, the influence of the warpage amount on the circuit pattern becomes substantially small.

Incidentally, as is clear from the graph of Fig. 3C, in a case where the rapid cooling start temperature is 400°C to 650°C, the warpage amount of the ceramic substrate 40 becomes less than the maximum permissible value of the warpage amount (in this case, less than 2 pm/mm) even when variation in the warpage amount is taken into consideration. In addition, when the rapid cooling start temperature is extremely lowered (for example, equal to or lower than 400°C), the productivity is decreased due to the extension of the firing time.

Therefore, in the present embodiment, an appropriate range of the rapid cooling start temperature is set to 400°C to 650°C in consideration of the balance between the warpage amount and the shortening of the firing time.

When the shortening of the firing time is not taken into consideration, the rapid cooling start temperature may be set to lower than 400°C.

What has been described above is the technical meaning of setting the rapid cooling region F4 in the cooling region F3.

### [Technical meaning of performing outer peripheral portion-cutting step S3]

Next, the technical meaning of performing the outer peripheral portion-cutting step S3 will be described with reference to Fig. 4B.

The inventors of the present application performed a test for measuring the warpage amounts of the ceramic substrate 40 in cases where the cut widths of the outer peripheral portions were set to 0 mm (no cutting), 3 mm, 6 mm, and 9 mm taking a case where the rapid cooling start temperature was 650°C as an example. Fig. 4B is a graph of the results, that is, a graph showing the relationship between the cut widths of the outer peripheral portions and the warpage amounts in the outer peripheral portion-cutting step S3. As is clear from the graph of Fig. 4B, it is found that, as the cut width of the outer peripheral portion increases, the warpage amount decreases. In addition, it is found that, as the cut width of the outer peripheral portion increases, the variation in the warpage amount decreases. The reason therefor is considered that, since a compressive stress or tensile stress applied due to the influence of cooling increases as the portion comes closer to the outer peripheral portion in the ceramic substrate 40, the ceramic substrate 40 is released from such stress by cutting such a portion. In addition, when the results of the graph of Fig. 4B are taken into account, it is necessary to cut the outer peripheral portions. However, since the cut outer peripheral portions of the ceramic substrate 40 are discarded, that is, the amount of the cut outer peripheral portions discarded increases as the cut widths increase, the cut widths of the outer peripheral portions are preferably narrow.

Therefore, in the present embodiment, the cut width of the outer peripheral portion is preferably set to equal to or less than 3 mm.

What has been described above is the technical meaning of performing the outer peripheral portion-cutting step S3.

Hitherto, the features and the like of the ceramic substrate 40 of the present embodiment have been described.

### <Scribe line-forming step>

Next, the SL forming step S4 will be described with reference to Fig. 5. The present step is a step of forming a plurality of scribe lines SL (three in the present embodiment as an example) on one surface of the ceramic substrate 40 (the front surface 40A1 in the present embodiment as an example) . When the present step is completed, an SL-drawn ceramic substrate 40A is manufactured.

In the present step, as an example, a total of three linear portions, that is, one linear portion passing through the center in the width direction and two linear portions equally dividing the ceramic substrate 40 in the length direction are formed on the front surface 40A1 of the ceramic substrate 40 with laser beams radiated from the radiation portion (not shown), and the entire region of the front surface 40A1 is partitioned into six equally-divided regions. Here, each scribe line SL is made up of a plurality of concave portions linearly arranged as an example (refer to Fig. 6B) . Therefore, the radiation portion that is used in the present step (as an example, a carbon dioxide laser beam source, a YAG laser beam source, or the like) is capable of, for example, intermittently radiating laser beams.

Each scribe line SL is used as a cutting line at the time of dividing the ceramic substrate 40 into a plurality of parts (six in the present embodiment) in the dividing step S9 (refer to Fig. 1), which is a below step.

Hitherto, the SL forming step S4 has been described.

### <Metal layer-forming step>

Next, the metal layer-forming step S5 will be described with reference to Fig. 6A and Fig. 6B.

The present step is a step of fixing the first metal layer 50A and the second metal layer 50B to the front surface 40A1 side and the rear surface 40A2 side of the SL-drawn ceramic substrate 40A, respectively. In this case, the first metal layer 50A and the second metal layer 50B are fixed to the front surface 40A1 side and the rear surface 40A2 side, respectively, through a brazing material (not shown) . Specifically, a paste-like brazing material is uniformly applied to the front surface 40A1 and the rear surface 40A2 of the ceramic substrate 40 by a method such as a roll coating method, a screen printing method, or a transfer method, and furthermore, the first metal layer 50A and the second metal layer 50B are joined to the front surface 40A1 and the rear surface 40A2 of the ceramic substrate 40, respectively, through the uniformly-applied paste-like brazing material. Here, in the present step, a screen printing method is preferable from the viewpoint of uniformly applying the paste-like brazing material. In addition, in this case, the clay of the paste-like brazing material is preferably controlled to 5 Pa·s to 20 Pa·s. An excellent paste-like brazing material can be obtained by blending an organic solvent in an amount of 5% by mass to 7% by mass and a binder in an amount within a range of 2% by mass to 8% by mass with the paste-like brazing material. When the present step is completed, the motherboard 60 is manufactured.

Fig. 6B shows a state where microcracks MC extending from the plurality of concave portions configuring the scribe line SL, respectively, to the rear surface 40A2 are formed, and the microcracks MC are formed at the time of the dividing step S9 to be described below. In addition, the microcracks MC are also formed at the time of the outer peripheral portion-cutting step S3.

Hitherto, the metal layer-forming step S5 has been described.

### <Resist printing step>

Next, the resist printing step S6 will be described with reference to Fig. 7. The present step is a step of coating the first metal layer 50A of the motherboard 60 with a photosensitive resist film PRF and forming resist patterns PRP corresponding to individual circuit patterns CP to be described below in six regions partitioned by the three scribe lines SL on the first metal layer 50A. Specifically, in the present step, the resist patterns PRP are printed on the resist film PRF using, as an example, an exposure device (not shown) (the resist patterns PRP are cured, and portions other than the resist patterns PRP in the resist film PRF are left uncured). As a result, the PRP-drawn motherboard 60A is manufactured.

Hitherto, the resist printing step S6 has been described.

### <Etching step>

Next, the etching step S7 (an example of the circuit pattern-forming step) will be described with reference to Fig. 8. The present step is a step of removing the uncured resist film PRF from the resist film PRF of the PRP-drawn motherboard 60A, etching portions where the first metal layer 50A is exposed, and then the remaining resist patterns PRP are removed to form the circuit pattern CP. As a result, the PRP-drawn motherboard 60A before the present step becomes the assembly substrate 60B in which the circuit pattern CP is formed in each of the six regions partitioned by the three scribe lines SL. In addition, when the assembly substrate 60B is formed, all of the portions of the three scribe lines SL formed in the SL forming step S4 are exposed due to the etching of the first metal layer 50A.

Electronic components (not shown) such as an IC, a capacitor, and a resistor are mounted on individual circuit patterns CP formed in the present step in the mounting step S10 to be described below. In addition, in the above description, the etching step S7 is described as an example of the circuit pattern-forming step, but the combination of the resist printing step S6 and the etching step S7 may be regarded as an example of the circuit pattern-forming step.

Hitherto, the etching step S7 has been described.

### <Surface treatment step>

Next, the surface treatment step S8 will be described. The present step is a step of performing a surface treatment on portions other than joint portions to which the electronic components are to be joined on the surface of the assembly substrate 60B on which the plurality of (six in the present embodiment) circuit patterns CP have been formed by coating the portions other than the joint portions with a protective layer such as a solder resist (not shown) . In addition, in the present step, a surface treatment of the joint portions is performed by performing a plating treatment by, for example, the electrolytic plating method on the joint portions to which the electronic components are to be joined. Here, in the above description, a product at the time of the completion of the etching step S7 is the assembly substrate 60B, but the product at the completion of the surface treatment step S8, that is, a substrate obtained by coating the assembly substrate 60B with the protective layer may be regarded as the assembly substrate.

Hitherto, the surface treatment step S8 has been described.

### <Dividing step>

Next, the dividing step S9 will be described with reference to Fig. 9. The present step is a step of dividing the assembly substrate 60B (or the SL-drawn ceramic substrate 40A) into a plurality of (six in the present embodiment as an example) the circuit substrates 60C by cutting the assembly substrate 60B along the plurality of (three in the present embodiment as an example) scribe lines SL.

When the present step is completed, a plurality of the circuit substrates 60C are manufactured. In the case of the present embodiment, the first metal layer 50A becomes the circuit pattern CP of each circuit substrate 60C by the steps described thus far. On the other hand, each region partitioned by the three scribe lines SL in the second metal layer 50B becomes the metal layer on the side of each circuit substrate 60C opposite to the side on which the circuit pattern CP has been formed by the steps described thus far. In addition, the metal layer functions as a heat dissipation layer for dissipating heat generated from the electronic component mounted on the circuit pattern CP while the mounting substrate (not shown) to be manufactured by the mounting step S10 to be described below is in use.

Hitherto, the dividing step S9 has been described.

In the description of the manufacturing method of the present embodiment thus far, the metal layer-forming step S5 is performed on the motherboard 60, and then the dividing step S9 is performed, however, for example, the dividing step S9 may be performed after the scribe line-forming step S4 and then the surface treatment step S8 may be performed after the metal layer-forming step S5.

### <Mounting step>

Next, the mounting step S10 will be described. The present step is a step of mounting the electronic component (not shown) on each circuit substrate 60C (refer to Fig. 9). In the present step, solder (not shown) is attached to the joint portion to which the electronic component is to be joined on the circuit pattern CP on each circuit substrate 60C (refer to Fig. 9) using a mounting device (not shown), and a joint terminal of the electronic component is attached to the joint portion.

When the present step is completed, a plurality of the mounting substrates are manufactured. In the above description, the present step is a step after the dividing step S9, but the dividing step S9 may be performed after the present step. That is, the manufacturing method S100 of the present embodiment may be performed in the order of the mounting step S10 and the dividing step S9 after the surface treatment step S8.

Hitherto, the mounting step S10 has been described. After the manufacturing of the plurality of mounting substrates, inspection of the circuit patterns CP, inspection of the operation of the electronic components, and the like are performed using, for example, an inspection device (not shown).

The manufacturing method S100 of the present embodiment has been thus far described.

### <<Effects of the present embodiment>>

Next, the effects of the present embodiment will be described.

### <First effect>

The ceramic substrate 40 of the present embodiment (refer to Fig. 3A, Fig. 3D, Fig. 3G, Fig. 3J, Fig. 3M, Fig. 3P, and the like) has the above-described basic features. Specifically, the ceramic substrate 40 of the present embodiment is a ceramic substrate 40 having a rectangular shape in a plan view, in which, at a location deviating from an intersection formed by a pair of diagonal lines of the ceramic substrate, at least one convex portion that is convex toward one side or the other side in a sheet thickness direction is formed, and a value obtained by dividing a maximum projection amount of the at least one convex portion by a length of the diagonal line of the ceramic substrate 40 is equal to or less than 2 pm/mm.

In addition, as described above, the ceramic substrate 40 of the present embodiment is processed into the circuit substrate 60C (refer to Fig. 9) by fixing the first metal layer 50A and the second metal layer 50B to both surface sides thereof, respectively. Therefore, various heat histories are applied to the ceramic substrate 40 of the present embodiment in a state where the first metal layer 50A and the second metal layer 50B are fixed to both surface sides thereof, respectively (a state of the motherboard 60). That is, thermal strain or thermal stress is generated inside the motherboard 60.

However, the ceramic substrate 40 of the present embodiment has the above-described configuration, whereby it is possible to produce a circuit substrate having excellent flatness in which residual thermal strain or residual thermal stress is significantly reduced.

In particular, when the substrate is manufactured such that a minute unevenness as shown in Fig. 3S to Fig. 3W is formed, the joining property with adjacent layers is enhanced compared with conventional substrates.

### <Second effect>

In addition, a part of the ceramic substrate 40 of the present embodiment is based on the premise of the above-described basic feature and has the following feature: the at least one convex portion is a plurality of convex portions, and the plurality of convex portions are formed in two regions partitioned by one diagonal line of the pair of diagonal lines of the ceramic substrate 40, respectively (refer to Fig. 3D, Fig. 3G, Fig. 3J, and Fig. 3M).

Therefore, the ceramic substrate 40 of the present embodiment having the above-described feature enables the production of a circuit substrate having excellent flatness in which residual thermal strain or residual thermal stress is significantly reduced compared with ceramic substrate not having the above-described feature (for example, refer to Fig. 3P).

### <Third effect>

In addition, a part of the ceramic substrate 40 of the present embodiment is based on the premise of the above-described basic feature and has the following feature: the at least one convex portion is a plurality of convex portions, and the plurality of convex portions are formed in four regions partitioned by the pair of diagonal lines of the ceramic substrate, respectively (refer to Fig. 3M).

Therefore, the ceramic substrate 40 of the present embodiment having the above-described feature enables the production of a circuit substrate having excellent flatness in which residual thermal strain or residual thermal stress is significantly reduced compared with ceramic substrate not having the above-described feature (for example, refer to Fig. 3D, Fig. 3G, Fig. 3J, and Fig. 3M) .

### <Fourth effect>

In addition, a part of the ceramic substrate 40 of the present embodiment is based on the premise of the above-described basic feature and has the following feature: the at least one convex portion is a plurality of convex portions, a part of the plurality of convex portions may be formed to become convex toward one side in the sheet thickness direction, and the remaining part of the plurality of convex portions may be formed to become convex toward the other side in the sheet thickness direction (for example, refer to Fig. 3D, Fig. 3M, and Fig. 3P).

Therefore, the ceramic substrate 40 of the present embodiment having the above-described feature enables the production of a circuit substrate having excellent flatness in which residual thermal strain or residual thermal stress is significantly reduced compared with ceramic substrate not having the above-described feature (for example, refer to Fig. 3G and Fig. 3J).

### <Fifth effect>

As shown in Fig. 6A and Fig. 6B, the motherboard 60 of the present embodiment includes the ceramic substrate 40, the first metal layer 50A fixed to the front surface 40A1 side of the ceramic substrate 40, and the second metal layer 50B fixed to the rear surface 40A2 side of the ceramic substrate 40.

In addition, the ceramic substrate 40 included in the motherboard 60 of the present embodiment has the above-described first to fourth effects.

Therefore, the motherboard 60 of the present embodiment includes the ceramic substrate 40 of the present embodiment, whereby residual thermal strain or residual thermal stress is significantly reduced and the flatness is excellent.

### <Sixth effect>

As shown in Fig. 9, the circuit substrate 60C of the present embodiment includes the ceramic substrate 40, the circuit pattern CP formed on one surface side of the ceramic substrate 40 (in the present embodiment, on the front surface 40A1 side as an example), and the metal layer fixed to the other surface side (in the present embodiment, to the rear surface 40A2 side as an example) of the ceramic substrate 40 (the second metal layer 50).

In addition, the ceramic substrate 40 included in the circuit substrate 60C of the present embodiment has the above-described first to fourth effects.

Therefore, the circuit substrate 60C of the present embodiment includes the ceramic substrate 40 of the present embodiment, whereby residual thermal strain or residual thermal stress is significantly reduced and the flatness is excellent.

### <Seventh effect>

The manufacturing method of the ceramic substrate 40 of the present embodiment includes the cutting step of cutting the strip-shaped green sheet 20 containing the ceramic powder to obtain the individual green sheet 30 (refer to Fig. 2B, Fig. 2C, and the like) and the sintering step of disposing the individual green sheet 30 in the firing chamber, heating the inside of the firing chamber until the temperature in the firing chamber reaches at least equal to or higher than 1600°C, then, cooling the inside of the firing chamber, and sintering the individual green sheet 30 to obtain the ceramic substrate 40, and, in the sintering step, the temperature in the firing chamber is rapidly cooled in a case where the temperature in the firing chamber at the time of cooling the inside of the firing chamber has reached equal to or lower than 650°C (refer to Fig. 3B).

As a result, according to the manufacturing method of the ceramic substrate 40 of the present embodiment, it is possible to manufacture the ceramic substrate 40 having excellent flatness in which residual thermal strain or residual thermal stress is significantly reduced (refer to Fig. 3C).

### <Eighth effect>

The manufacturing method of the ceramic substrate 40 of the present embodiment further includes a cutting step of cutting portions on the entire peripheral edge sides of the ceramic substrate 40 cooled after the sintering step (refer to Fig. 4A) .

As a result, the ceramic substrate 40 from which the entire peripheral edge sides have been cut is released from a state where a compressive stress or tensile stress is applied due to the influence during the cooling, that is, particularly, stress in the outer peripheral edges.

As a result, according to the manufacturing method of the ceramic substrate 40 of the present embodiment, it is possible to manufacture the ceramic substrate 40 having excellent flatness in which residual thermal strain or residual thermal stress is significantly reduced (refer to Fig. 4B).

### <Ninth effect>

The manufacturing method of the motherboard 60 of the present embodiment includes the manufacturing method of the ceramic substrate 40 of the present embodiment and the fixing step of fixing the first metal layer 50A to the front surface 40A1 side of the ceramic substrate 40 and fixing the second metal layer 50B to the rear surface 40A2 side (refer to Fig. 6A).

In addition, the manufacturing method of the ceramic substrate 40 of the present embodiment exhibits the above-described seventh effect.

Therefore, according to the manufacturing method of the motherboard 60 of the present embodiment, it is possible to manufacture the motherboard 60 in which residual thermal strain or residual thermal stress is significantly reduced and the flatness is excellent.

### <Tenth effect>

The manufacturing method of the circuit substrate 60C of the present embodiment includes the manufacturing method of the motherboard 60 of the present embodiment and the pattern-forming step of forming the circuit pattern CP on at least one of the first metal layer 50A and the second metal layer 50B (in the case of the present embodiment, the first metal layer 50A) (refer to Fig. 7, Fig. 8, and the like).

In addition, the manufacturing method of the motherboard 60 of the present embodiment exhibits the above-described eighth effect.

Therefore, according to the manufacturing method of the circuit substrate 60C of the present embodiment, it is possible to manufacture the circuit substrate 60C in which residual thermal strain or residual thermal stress is significantly reduced and the flatness is excellent.

Hitherto, the effects of the present embodiment have been described. In addition, the present embodiment has been thus far described.

### <<Modification examples>>

As described above, an example of the present invention has been described with reference to the above-described embodiment (refer to Fig. 1 to Fig. 9), but the present invention is not limited to the above-described embodiment. The technical scope of the present invention also includes, for example, forms as described below (modification examples).

For example, in the description of the present embodiment, description was made using silicon nitride as an example of the ceramic powder. However, the example of the ceramic powder may be a different ceramic powder. For example, the ceramic powder may be an aluminum nitride powder.

In addition, in the description of the molding step S12 (refer to Fig. 2A) included in the green sheet-forming step S1 of the present embodiment, the molding step S12 was performed using the doctor blade molding. However, the molding step S12 may be performed by a different method as long as it is possible to mold the slurry 10 into the strip-shaped green sheet 20. For example, the molding step S12 may be performed by extrusion molding.

In addition, in the description of the cutting step S13 (refer to Fig. 2A) included in the green sheet-forming step S1 of the present embodiment, the strip-shaped green sheet 20 was cut while the radiation portion 224 was moved from one end side to the other end side of the strip-shaped green sheet 20 in the lateral direction. However, as long as the individual green sheet 30 can be consequently obtained by cutting the strip-shaped green sheet 20, the cutting site of the strip-shaped green sheet 20 may not be a linear portion from one end side to the other end side of the strip-shaped green sheet 20 in the lateral direction as in the case of the present embodiment. For example, the strip-shaped green sheet 20 may be cut so as to separate (or hollow out) the individual green sheet 30 from the strip-shaped green sheet 20 by opening pilot holes in the form of the individual green sheet 30 in the strip-shaped green sheet 20. That is, at least a part of the entire end faces of the individual green sheet 30 obtained by cutting the strip-shaped green sheet 20 needs to be a cut surface.

In addition, in the present embodiment, the circuit pattern CP has been described to be formed on the first metal layer 50A. However, the circuit pattern CP may be formed on the second metal layer 50B without forming the circuit pattern CP on the first metal layer 50A. That is, in the pattern-forming step (the resist printing step S6 and the etching step S7), at least one circuit pattern CP may be formed on any one of the first metal layer 50A and the second metal layer 50B.

In addition, in the present embodiment, the plurality of linearly-arranged concave portions have been described as the scribe lines SL (refer to Fig. 6B). However, the scribe lines SL maybe, for example, continuous grooves, a plurality of concave portions having different lengths, widths, or the like, or the like as long as the function can be exhibited.

In addition, in the present embodiment, the plurality of scribe lines SL have been described as three scribe lines SL (refer to Fig. 5) . However, the number of the plurality of scribe lines SL may be at least equal to or more than one.

In addition, in the present embodiment, the plurality of scribe lines SL have been described to equally divide the motherboard 60 into six parts (refer to Fig. 5). However, the plurality of scribe lines SL may not equally divide the motherboard 60.

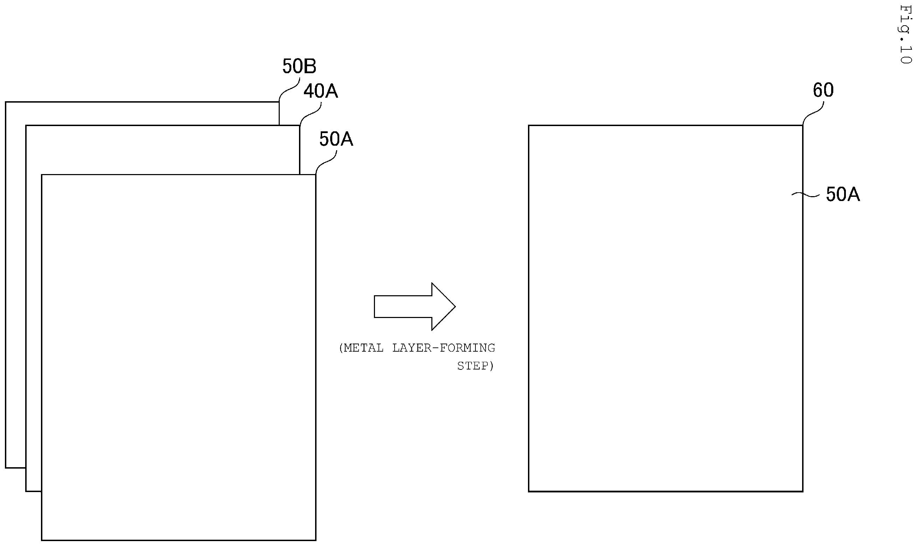

In addition, in the manufacturing method S100 of the present embodiment, it has been described that the SL forming step S4 was performed (refer to Fig. 1). However, as in a modification example shown in Fig. 10, the metal layer-forming step S5 may be performed without performing the SL forming step S4 after the outer peripheral portion-cutting step S3. In the case of this modification example, if the mounting step S10 is performed without performing the dividing step S9 after the surface treatment step S8 (refer to Fig. 1), one mounting substrate is manufactured from one motherboard 60.

In addition, the manufacturing method of the ceramic substrate 40 of the present embodiment has been described to include the outer peripheral portion-cutting step S3 (refer to Fig. 1, Fig. 4A, and Fig. 4B). However, depending on the conditions of the sintering step S2, since it is possible to suppress the warpage amount of the ceramic substrate 40 to equal to or less than the maximum permissible value, the outer peripheral portion-cutting step S3 may not be an essential configuration element.

This application claims priority on the basis of Japanese Patent Application No. 2019-206751 filed on November 15, 2019.

### REFERENCE SIGNS LIST

- 10:: Slurry
- 20:: Strip-shaped green sheet
- 30:: Individual green sheet
- 40:: Ceramic substrate
- 40A:: SL-drawn ceramic substrate
- 40A1:: Front surface
- 40A2:: Rear surface
- 50A:: First metal layer
- 50B:: Second metal layer
- 60:: Motherboard (example of composite substrate)
- 60A:: PRP-drawn motherboard
- 60B:: Assembly substrate
- 60C:: Circuit substrate
- 100:: Doctor blade molding device
- 110:: Belt transport mechanism
- 112:: Roller
- 112A:: Roller
- 112B:: Roller
- 114:: Belt
- 120:: Molding unit
- 122:: Accommodation portion
- 124:: Doctor blade
- 130:: Heating unit
- 200:: Cutting device
- 210:: Sheet transport mechanism
- 212:: Support portion
- 214:: First transport portion
- 216:: Second transport portion
- 220:: Cutting portion
- 222:: Housing
- 224:: Radiation portion
- 226:: Moving mechanism
- CX1:: Convex portion
- CX2:: Convex portion
- CX3:: Convex portion
- CX4:: Convex portion
- CP:: Circuit pattern
- F1:: Temperature raising region
- F1:: Slow heating region
- F2:: Temperature holding region
- F3:: Cooling region
- F4:: Rapid cooling region
- L1:: Straight line (first straight line)
- L2:: Straight line (second straight line)
- LB:: Laser beam
- MC:: Microcrack
- O:: Intersection, center
- PRF:: Resist film
- PRP:: Resist pattern
- S1:: Green sheet-forming step
- S10:: Mounting step
- S11:: Slurry production step
- S12:: Molding step
- S13:: Cutting step
- S14:: Deposition step
- S15:: Degreasing step
- S2:: Sintering step
- S3:: Outer peripheral portion-cutting step
- S4:: SL forming step (scribe line-forming step)
- S5:: Metal layer-forming step
- S6:: Resist printing step
- S7:: Etching step
- S8:: Surface treatment step
- S9:: Dividing step
- S100:: Manufacturing method of plurality of mounting substrates
- SL:: Scribe line
- WC:: Warm air
- ΔZ₁:: Projection amount
- ΔZ₂:: Projection amount
- ΔZ₃:: Projection amount
- ΔZ₄:: Projection amount

## Claims

1. A ceramic substrate (40) having a rectangular shape in a plan view,
wherein, at a location deviating from an intersection (O) formed by a pair of diagonal lines of the ceramic substrate (40), at least one convex portion (CX) that is convex toward one side or the other side in a sheet thickness direction is formed, and
a value obtained by dividing a maximum projection amount (Δz) of the at least one convex portion (CX) by a length of the diagonal line of the ceramic substrate (40) is equal to or less than 2 pm/mm,
**characterized in that** the convex portion (CX) having the maximum projection amount (Δz) among said convex portions (CX) that are convex toward one side or the other in the sheet thickness direction is at the outer peripheral edge portions of said ceramic substrate (40), wherein the diagonal lines have a length of 150 mm or more and the outer peripheral edge portion is an area within 3 mm from the outer edge of the ceramic substrate (40).

2. The ceramic substrate (40) of claim 1, wherein the diagonal lines have a length of 200 mm or more, and preferably of 236 mm or more.

3. The ceramic substrate (40) of claim 1 or 2, wherein the diagonal lines have a length of 254 mm or less.

4. A composite substrate (60) comprising:
the ceramic substrate (40) according to Claim 1;
a first metal layer (50A) fixed to a front surface side (40A1) of the ceramic substrate (40); and
a second metal layer fixed (50B) to a rear surface side (40A2) of the ceramic substrate (40).

5. A circuit substrate (60C) comprising:
the ceramic substrate (40) according to Claim 1 or 2;
a circuit pattern (CP) formed on a front surface side (40A1) of the ceramic substrate (40); and
a metal layer (50B) fixed to a rear surface side (40A2) of the ceramic substrate (40).

6. A manufacturing method of the ceramic substrate (40) according to Claim 1, comprising:
a strip-shaped green sheet-cutting step (s13) of cutting a strip-shaped green sheet (20) containing a ceramic powder to obtain an individual green sheet (30); and
a sintering step (S2) of disposing the individual green sheet (30) in a firing chamber, heating an inside of the firing chamber until a temperature in the firing chamber reaches at least equal to or higher than 1600°C, then, cooling the inside of the firing chamber, and sintering the individual green sheet to obtain the ceramic substrate (40),
wherein the sintering step (s2) comprises a cooling region (F3) in which the temperature in the firing chamber is cooled at a cooling rate of 100 °C/hour or more, the cooling region (F3) including a rapid cooling region (F4) in which the cooling rate is further increased when the temperature in the firing chamber during the cooling of the inside of the firing chamber reaches a temperature of equal to or lower than 650°C.

7. The manufacturing method of the ceramic substrate (40) according to Claim 6,
wherein the ceramic powder contains silicon nitride powder or aluminum nitride powder.

8. A method of cutting a ceramic substrate (40) comprising:
performing the method according to Claims 6 or 7, further comprising
a ceramic substrate-cutting step (s3) of cutting portions on entire peripheral edge sides of the ceramic substrate (40) cooled after the sintering step (s2).

9. A manufacturing method of a composite substrate (60), comprising:
performing the method according to any one of Claims 6 to 8; and
a fixing step of fixing a first metal layer (50A) to a front surface side (40A1) of the ceramic substrate (40) and fixing a second metal layer (50B) to a rear surface side (40A2).

10. A manufacturing method of a circuit substrate (60C), comprising:
the manufacturing method of a composite substrate (60) according to Claim 9; and
a pattern-forming step of forming at least one circuit pattern (CP) on any one of the first metal layer (50A) and the second metal layer (50B).

11. A manufacturing method (s100) of a plurality of circuit substrates (60C), comprising:
the manufacturing method of a composite substrate (60) according to Claim 9;
a pattern-forming step of forming a plurality of circuit patterns (CP) on any one of the first metal layer (50A) and the second metal layer (50B); and
a dividing step (s9) of dividing the composite substrate (60) on which the plurality of circuit patterns (CP) have been formed into a plurality of circuit substrates (60C) each having one circuit pattern (CP).

## Patentansprüche

1. Keramiksubstrat (40), das in einer Draufsicht eine rechteckige Form aufweist,
wobei an einer Stelle, die von einem Schnittpunkt (O), der durch ein Paar diagonaler Linien des Keramiksubstrats (40) ausgebildet wird, abweicht, wenigstens ein konvexer Abschnitt (CX) ausgebildet ist, der nach einer Seite oder der anderen Seite in einer Dickenrichtung des Flächengebildes konvex ist, und
ein Wert, der durch Dividieren eines höchsten Vorsprungsmaßes (Δz) des wenigstens einen konvexen Abschnitts (CX) durch eine Länge der diagonalen Linie des Keramiksubstrats (40) erhalten wird, gleich oder kleiner als 2 pm/mm ist,
**dadurch gekennzeichnet, dass** der das höchste Vorsprungsmaß (Δz) aufweisende konvexe Abschnitt (CX) aus den konvexen Abschnitten (CX), die nach einer Seite oder der anderen in der Dickenrichtung des Flächengebildes konvex sind, sich an den äußeren peripheren Randabschnitten des Keramiksubstrats (40) befindet, wobei die diagonalen Linien eine Länge von 150 mm oder mehr aufweisen und der äußere periphere Randabschnitt ein Bereich innerhalb von 3 mm vom äußeren Rand des Keramiksubstrats (40) ist.

2. Keramiksubstrat (40) nach Anspruch 1, wobei die diagonalen Linien eine Länge von 200 mm oder mehr und vorzugsweise von 236 mm oder mehr aufweisen.

3. Keramiksubstrat (40) nach Anspruch 1 oder 2, wobei die diagonalen Linien eine Länge von 254 mm oder weniger aufweisen.

4. Verbundsubstrat (60), umfassend:
das Keramiksubstrat (40) nach Anspruch 1;
eine erste Metallschicht (50A), die an einer Vorderflächenseite (40A1) des Keramiksubstrats (40) befestigt ist; und
eine zweite Metallschicht (50B), die an einer Rückflächenseite (40A2) des Keramiksubstrats (40) befestigt ist.

5. Schaltungssubstrat (60C), umfassend:
das Keramiksubstrat (40) nach Anspruch 1 oder 2;
eine Schaltungsstruktur (CP), die auf einer Vorderflächenseite (40A1) des Keramiksubstrats (40) ausgebildet ist; und
eine Metallschicht (50B), die an einer Rückflächenseite (40A2) des Keramiksubstrats (40) befestigt ist.

6. Herstellungsverfahren für das Keramiksubstrat (40) nach Anspruch 1, umfassend:
einen das Schneiden eines streifenförmigen flächigen Grünlings umfassenden Schritt (s13) des Schneidens eines streifenförmigen flächigen Grünlings (20), der ein Keramikpulver enthält, zum Erhalten eines einzelnen flächigen Grünlings (30); und
einen Sinterschritt (S2) des Anordnens des einzelnen flächigen Grünlings (30) in einer Brennkammer, des Erhitzens eines Inneren der Brennkammer, bis eine Temperatur in der Brennkammer wenigstens 1600 °C oder mehr erreicht, und des anschließenden Abkühlens des Inneren der Brennkammer und Sinterns des einzelnen flächigen Grünlings, um das Keramiksubstrat (40) zu erhalten,
wobei der Sinterschritt (s2) einen Abkühlbereich (F3) umfasst, in dem die Temperatur in der Brennkammer mit einer Abkühlgeschwindigkeit von 100 °C/Stunde oder mehr verringert wird, wobei der Abkühlbereich (F3) einen Schnellabkühlbereich (F4) umfasst, in dem die Abkühlgeschwindigkeit weiter erhöht wird, wenn die Temperatur in der Brennkammer während des Abkühlens des Inneren der Brennkammer eine Temperatur von 650 °C oder weniger erreicht.

7. Herstellungsverfahren für das Keramiksubstrat (40) nach Anspruch 6,
wobei das Keramikpulver Siliciumnitridpulver oder Aluminiumnitridpulver enthält.

8. Verfahren zum Schneiden eines Keramiksubstrats (40), umfassend:
Durchführen des Verfahrens nach den Ansprüchen 6 oder 7, ferner umfassend:
einen das Schneiden eines Keramiksubstrats umfassenden Schritt (s3) des Schneidens von Abschnitten an gesamten peripheren Randseiten des nach den Sinterschritt (s2) abgekühlten Keramiksubstrats (40).

9. Herstellungsverfahren für ein Verbundsubstrat (60), umfassend:
Durchführen des Verfahrens nach einem der Ansprüche 6 bis 8; und
einen Befestigungsschritt des Befestigens einer ersten Metallschicht (50A) an einer Vorderflächenseite (40A1) des Keramiksubstrats (40) und des Befestigens einer zweiten Metallschicht (50B) an einer Rückflächenseite (40A2).

10. Herstellungsverfahren für ein Schaltungssubstrat (60C), umfassend:
das Herstellungsverfahren für ein Verbundsubstrat (60) nach Anspruch 9; und
einen Strukturausbildungsschritt des Ausbildens wenigstens einer Schaltungsstruktur (CP) auf einer aus der ersten Metallschicht (50A) und der zweiten Metallschicht (50B).

11. Herstellungsverfahren (s100) für eine Mehrzahl von Schaltungssubstraten (60C), umfassend:
das Herstellungsverfahren für ein Verbundsubstrat (60) nach Anspruch 9;
einen Strukturausbildungsschritt des Ausbildens einer Mehrzahl von Schaltungsstrukturen (CP) auf einer aus der ersten Metallschicht (50A) und der zweiten Metallschicht (50B); und
einen Teilungsschritt (s9) des Teilens des Verbundsubstrats (60), auf dem die Mehrzahl von Schaltungsstrukturen (CP) ausgebildet wurde, in eine Mehrzahl von Schaltungssubstraten (60C) mit jeweils einer Schaltungsstruktur (CP).

## Revendications

1. Substrat céramique (40) présentant une forme rectangulaire dans une vue de dessus,
dans lequel au moins une partie convexe (CX), qui est convexe vers un côté ou l'autre côté dans une direction d'épaisseur de plaque, est formée à un emplacement situé à l'écart d'une intersection (O) formée par une paire de lignes diagonales du substrat céramique (40), et
une valeur obtenue en divisant une quantité de projection maximale (Δz) de l'au moins une partie convexe (CX) par une longueur de la ligne diagonale du substrat céramique (40) est égale ou inférieure à 2 um/mm,
**caractérisé en ce que** la partie convexe (CX) présentant la quantité de projection maximale (Δz) parmi lesdites parties convexes (CX) qui sont convexes vers un côté ou l'autre dans la direction d'épaisseur de plaque se trouve sur les parties marginales périphériques extérieures dudit substrat céramique (40), les lignes diagonales présentant une longueur supérieure ou égale à 150 mm et la partie marginale périphérique extérieure étant une zone comprise dans les 3 mm partant du bord extérieur du substrat céramique (40).

2. Substrat céramique (40) selon la revendication 1, dans lequel les lignes diagonales présentent une longueur supérieure ou égale à 200 mm, et de préférence supérieure ou égale à 236 mm.

3. Substrat céramique (40) selon la revendication 1 ou 2, dans lequel les lignes diagonales présentent une longueur inférieure ou égale à 254 mm.

4. Substrat composite (60) comprenant :
le substrat céramique (40) selon la revendication 1 ;
une première couche métallique (50A) fixée sur un côté surface avant (40A1) du substrat céramique (40) ; et
une seconde couche métallique (50B) fixée sur un côté surface arrière (40A2) du substrat céramique (40).

5. Substrat de circuit imprimé (60C) comprenant :
le substrat céramique (40) selon la revendication 1 ou 2 ;
un tracé de circuit (CP) formé sur un côté surface avant (40A1) du substrat céramique (40) ; et
une couche métallique (50B) fixée sur un côté surface arrière (40A2) du substrat céramique (40).

6. Procédé de fabrication du substrat céramique (40) selon la revendication 1, comprenant :
une étape de coupe de plaque verte en forme de bande (s13) consistant à couper une plaque verte en forme de bande (20) contenant une poudre céramique pour obtenir une plaque verte individuelle (30) ; et
une étape de frittage (S2) consistant à disposer la plaque verte individuelle (30) dans une chambre de cuisson, chauffer l'intérieur de la chambre de cuisson jusqu'à ce que la température dans la chambre de cuisson atteigne une température au moins égale ou supérieure à 1600 °C, puis refroidir l'intérieur de la chambre de cuisson et fritter la plaque verte individuelle pour obtenir le substrat céramique (40),
dans lequel l'étape de frittage (s2) comprend une région de refroidissement (F3) dans laquelle la température dans la chambre de cuisson est refroidie à une vitesse de refroidissement supérieure ou égale à 100 °C/heure, la région de refroidissement (F3) comportant une région de refroidissement rapide (F4) dans laquelle la vitesse de refroidissement est augmentée davantage quand la température dans la chambre de cuisson pendant le refroidissement de l'intérieur de la chambre de cuisson atteint une température égale ou inférieure à 650 °C.

7. Procédé de fabrication du substrat céramique (40) selon la revendication 6,
dans lequel la poudre céramique contient de la poudre de nitrure de silicium ou de la poudre de nitrure d'aluminium.

8. Procédé de coupe d'un substrat céramique (40) comprenant :
l'exécution du procédé selon la revendication 6 ou 7, comprenant en outre
une étape de coupe de substrat céramique (s3) consistant à couper des parties sur des côtés marginaux périphériques entiers du substrat céramique (40) refroidi après l'étape de frittage (s2).

9. Procédé de fabrication d'un substrat composite (60), comprenant :
l'exécution du procédé selon une des revendications 6 à 8 ; et
une étape de fixation consistant à fixer une première couche métallique (50A) sur un côté surface avant (40A1) du substrat céramique (40) et fixer une seconde couche métallique (50B) sur un côté surface arrière (40A2).

10. Procédé de fabrication d'un substrat de circuit imprimé (60C), comprenant :
le procédé de fabrication d'un substrat composite (60) selon la revendication 9 ; et
une étape de formation de tracé consistant à former au moins un tracé de circuit (CP) sur l'une quelconque de la première couche métallique (50A) et la seconde couche métallique (50B).

11. Procédé de fabrication (s100) d'une pluralité de substrats de circuit imprimé (60C), comprenant :
le procédé de fabrication d'un substrat composite (60) selon la revendication 9 ;
une étape de formation de tracé consistant à former une pluralité de tracés de circuit (CP) sur l'une quelconque de la première couche métallique (50A) et la seconde couche métallique (50B) ; et
une étape de division (s9) consistant à diviser le substrat composite (60) sur lequel la pluralité de tracés de circuit (CP) a été formée en une pluralité de substrats de circuit imprimé (60C) présentant chacun un tracé de circuit (CP) .
